(19) Europäisches Patentamt / European Patent Office / Office européen des brevets

(11) **EP 4 044 185 A1**

(12) **DEMANDE DE BREVET EUROPEEN**

(43) Date de publication:
**17.08.2022 Bulletin 2022/33**

(21) Numéro de dépôt: **22156192.1**

(22) Date de dépôt: **10.02.2022**

(51) Classification Internationale des Brevets (IPC):
*G11C 11/16* *(2006.01)*

(52) Classification Coopérative des Brevets (CPC):
**G11C 11/1675; G11C 11/161**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **11.02.2021 FR 2101317**

(71) Demandeurs:
• **Commissariat à l'Energie Atomique et aux Energies Alternatives**
**75015 Paris (FR)**
• **UNIVERSITE GRENOBLE ALPES**
**38400 Saint Martin d'Hères (FR)**
• **Institut National Polytechnique de Grenoble**
**38031 Grenoble (FR)**

• **Centre national de la recherche scientifique**
**75016 Paris (FR)**

(72) Inventeurs:
• **DIENY, Bernard**
**38054 Grenoble (FR)**
• **BRANDAO VEIGA, Pedro**
**38054 Grenoble (FR)**
• **SOUSA, Ricardo**
**38054 Grenoble (FR)**
• **BUDA-PREJBEANU, Liliana**
**38054 Grenoble (FR)**
• **BEA, Helene**
**38054 Paris (FR)**
• **GREZES, Cecile**
**38054 Grenoble (FR)**

(74) Mandataire: **Cabinet Camus Lebkiri**
**25 rue de Maubeuge**
**75009 Paris (FR)**

(54) **DISPOSITIF MAGNÉTIQUE CRYOGÉNIQUE PLUS PARTICULIÈREMENT POUR MÉMOIRE OU COMPOSANT LOGIQUE**

(57) L'invention concerne un dispositif (100) magnétique cryogénique comportant :
- une couche libre (110) présentant une aimantation libre et une anisotropie magnétique favorisant l'orientation de l'aimantation libre selon une première orientation ou une deuxième orientation, l'anisotropie magnétique étant définie par une barrière énergétique séparant la première orientation et la deuxième orientation, l'amplitude de la barrière énergétique étant inférieure à 6300 $k_B$, la couche libre présentant un facteur d'amortissement de Gilbert compris entre 0,02 et 0,4 ;
- une barrière tunnel (120) s'étendant au contact avec de la couche libre ; et
- un moyen (131, 132) configuré pour appliquer une impulsion de tension (V) à travers la barrière tunnel afin de réduire l'amplitude de la barrière énergétique et commuter l'aimantation libre.

[Fig. 3]

EP 4 044 185 A1

**Description**

**DOMAINE TECHNIQUE DE L'INVENTION**

Le domaine technique de l'invention est celui des dispositifs magnétiques destinés à être mis en œuvre plus particulièrement en tant que mémoire ou circuit logique dans un environnement cryogénique. La présente invention concerne plus particulièrement le changement d'état magnétique d'un dispositif magnétique mettant en œuvre un contrôle en tension de l'anisotropie magnétique dudit dispositif.

**ARRIÈRE-PLAN TECHNOLOGIQUE DE L'INVENTION**

Dans l'électronique numérique conventionnelle basée sur la technologie semi-conducteur/oxyde/métal complémentaires (CMOS), il y a une grande dissipation d'énergie statique et dynamique. La première est principalement due à diverses fuites de courant lorsque les transistors sont dans un état ouvert, tandis que la seconde est associée à la charge et décharge des interconnections capacitives reliant les différents composants du circuit. Cette consommation d'énergie croissante a stimulé un effort mondial important de recherche de solutions innovantes pour augmenter l'efficacité énergétique globale des systèmes électroniques.

Récemment, les technologies quantiques telles que les circuits logiques supraconducteurs à base de jonctions Josephson sont apparues comme des candidats prometteurs pour les futures architectures informatiques, bénéficiant d'une vitesse de traitement énorme, d'une faible consommation d'énergie ainsi que d'interconnexions rapides et sans perte entre les éléments de circuit. En parallèle, les récents développements techniques ont permis la réalisation d'infrastructures de calcul cryogénique à grande échelle, où l'économie d'énergie réalisée par le calcul à température cryogénique dépasse le coût de l'énergie nécessaire pour refroidir le système et le maintenir à basse température en fonctionnement. Ce passage aux infrastructures de calcul cryogénique nécessite l'adaptation de tous les composants microélectroniques associés pour un fonctionnement à basse température.

L'émergence des technologies de calcul quantique promet un accroissement des capacités de calcul. Toutefois ces technologies nécessitent le recours à un environnement cryogénique pour fonctionner correctement. La transition d'une infrastructure de calcul pouvant fonctionner à température ambiante à une infrastructure de calcul nécessitant un environnement cryogénique implique ainsi d'adapter les éléments associés, tels que les mémoires ou les circuits logiques, aux conditions cryogéniques.

Les mémoires non volatiles, notamment les mémoires magnétiques de type MRAM ("Magnetic Random access memory" en anglais), qui conservent leurs données en l'absence d'alimentation, sont intéressantes car elles permettent de diminuer la consommation énergétique en éteignant les parties temporairement inactives du circuit et donc en éliminant le courant de fuite dans ces parties. Le recours à une source d'énergie n'est alors nécessaire que lors des phases de lecture ou d'écriture d'un état dans la mémoire non-volatile. Le concept de calcul électronique dans un circuit normalement éteint avec mise en marche instantanée ("Normally-Off/Instant-On computing" en langue anglaise) a même été introduit pour décrire cette approche ("Challenges toward gigabit-scale spin-transfer torque random access memory and beyond for normally off, green information technology infrastructure", Takayuki Kawahara, J. Appl. Phys. 109,07D325, 2011).

Plusieurs propositions [Vernik, I. V. et al. "Magnetic Josephson junctions with superconducting interlayer for cryogenic memory", IEEE Trans. Appl. Supercond. 23, 1701208, 2013], basées sur une jonction tunnel hybride magnétique et supraconductrice, ont été faites pour étendre le domaine d'application des mémoires magnétiques de type MRAM à l'environnement cryogénique. En revanche ces dispositifs hybrides présentent des problèmes de déploiement à grande échelle par rapport aux mémoires magnétiques comprenant une jonction tunnel entièrement magnétique.

Plusieurs propositions de mémoires entièrement magnétiques, basées sur une jonction tunnel magnétique ou une vanne de spin, font intervenir la circulation d'un courant polarisé en spin au sein de la mémoire magnétique afin de changer l'état de ladite mémoire magnétique.

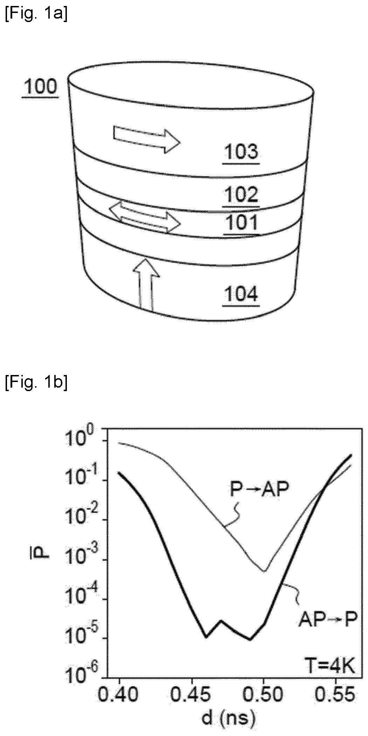

Une première proposition [G. E. Rowlands et al. "A cryogenic spin-torque memory element with precessional magnetization dynamics", Scientific Reports 9, 803, 2019] divulgue une mémoire magnétique, représentée par la figure 1a, destinée à être opérée à très basse température (4 K) et comprenant une vanne de spin. La mémoire magnétique 100 comprend une couche de polarisation 104, présentant une aimantation hors du plan des couches, une couche libre 101 présentant une aimantation variable appartenant au plan des couches, une couche de référence 103 présentant une aimantation fixe appartenant au plan des couches et une couche métallique non-magnétique 102 séparant la couche libre 101 et la couche de référence 103. Une impulsion de courant électrique, polarisé par la couche de polarisation 104, exerce un couple sur la couche libre 101, induisant un mouvement de précession cohérent de l'aimantation autour de la normale au plan des couches. Le retournement de l'aimantation de la couche libre 101, aussi appelé basculement, renversement ou commutation, est alors obtenu par un ajustement approprié de la durée de l'impulsion de courant. La figure 1b présente un taux d'erreur du retournement de l'aimantation $\overline{P}$ (aussi appelé taux d'erreur d'écriture) en fonction de la durée d de l'impulsion de courant. L'écriture n'est réalisée avec succès que dans une gamme très limitée de conditions d'impulsion et avec un taux d'erreur d'écriture assez élevé de l'ordre de $10^{-3}$. Un tel contrôle de la durée des impulsions (durée de l'ordre de 500ps $\pm$ 30ps) est très difficile à réaliser au niveau d'une puce électronique comportant un grand nombre de dispositifs magnétiques en raison de la déformation des impulsions de courant lorsqu'elles se propagent dans les lignes conductrices connectées aux dispositifs magnétiques. En outre, la durée optimale des impulsions s'avère différente pour les transitions de parallèle (P, lorsque l'aimantation des couches de référence et libre sont parallèles) vers antiparallèle (AP, lorsque l'aimantation des couches de références et libre sont antiparallèles) où 500 ps sont nécessaires alors que, d'antiparallèle (AP) vers parallèle (P), 470 ps suffisent, rendant le retournement d'autant plus difficile à contrôler. De plus, ce dispositif est entièrement composé de couches métalliques, présentant une magnétorésistance géante perpendiculaire au plan du courant qui n'est que de l'ordre de 1%, trop faible pour être utilisable au niveau de la puce.

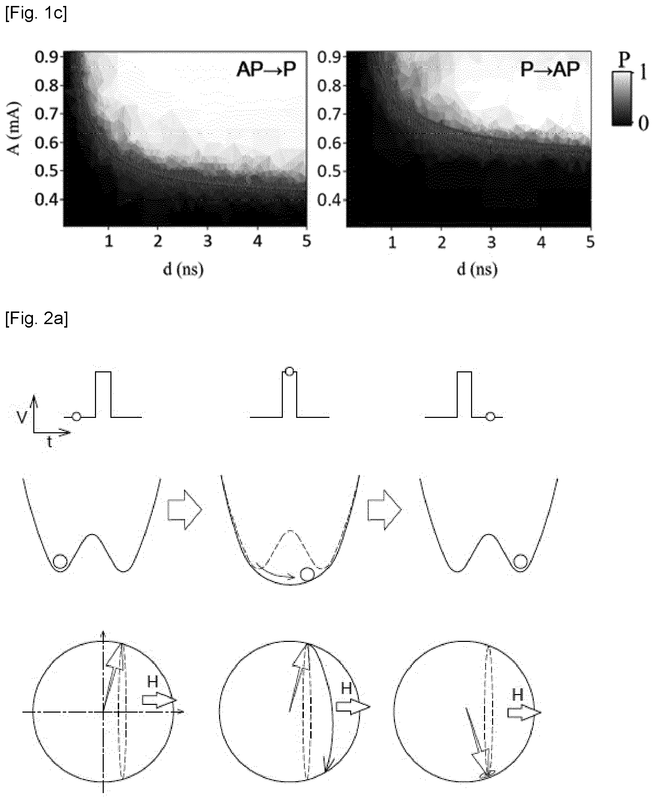

Une deuxième proposition [L. Rehm et al. "Sub-nanosecond switching in a cryogenic spin-torque spin-valve memory element with a dilute permalloy free layer", Appl. Phys. Lett. 114, 212402, 2019] divulgue une mémoire magnétique, également destinée à être opérée à très basse température (3,2 K) et comprenant une vanne de spin. En revanche, dans cet exemple, la couche libre comprend un alliage de permalloy avec du cuivre (dit permalloy dilué). La mémoire comprend une couche de référence formée par une couche antiferromagnétique synthétique. La couche de référence présente une épaisseur de 3 nm et comprend un alliage de CoFe. L'aimantation de la couche de référence appartient au plan des couches. La structure antiferromagnétique synthétique comprend la couche de référence (CoFe), une couche d'espacement de 0,8 nm en ruthénium et une deuxième couche en alliage de CoFe. La mémoire comprend également une couche métallique non magnétique de 3,5 nm en cuivre séparant la couche libre de la couche de référence. Le retournement de l'aimantation de la couche libre est réalisé par une impulsion de courant de l'ordre de 0,7 mA pour une durée de 2 ns. La figure 1c présente en niveau de gris la probabilité de retournement de l'aimantation en fonction de l'amplitude A et de la durée d de l'impulsion. Comme le dispositif est entièrement métallique, la dépendance angulaire du couple de transfert de spin est très asymétrique, ce qui induit une probabilité de retournement différente en fonction des configurations de départ : antiparallèle (AP) et parallèle (P). En outre, comme dans l'exemple précédent, la magnétorésistance du dispositif est ici aussi trop faible pour des applications pratiques.

Une troisième proposition [L. Rehm et al. "Sub-nanosecond spin-torque switching of perpendicular magnetic tunnel junction nanopillars at cryogenic temperatures", Appl. Phys. Lett. 115, 182404, 2019] divulgue une mémoire magnétique comprenant une jonction tunnel magnétique perpendiculaire (ou pMTJ pour "perpendicular Magnetic Tunnel Junction" en anglais), afin de surmonter le problème de faible magnétorésistance des approches précédentes. Pour rappel, une jonction tunnel magnétique perpendiculaire comprend une couche libre dont l'aimantation est orientée perpendiculairement au plan des couches. La jonction tunnel magnétique perpendiculaire comprend en outre une barrière tunnel à base d'oxyde de magnésium MgO et présente un rapport de magnétorésistance tunnel de 203%. De plus, à très basse température (4 K), le retournement de l'aimantation de la couche libre est obtenu grâce à une impulsion de courant de 4 ns avec un taux d'erreur de l'ordre de $10^{-5}$. Cependant, comme le montre le tableau 1 ci-dessous, l'énergie de retournement E augmente avec la baisse de la température $T$ pour atteindre 286 fJ à 4 K qui constitue une consommation électrique incompatible avec l'intégration des technologies quantiques et des infrastructures de calcul cryogénique à grande échelle.

[Table 1]

| T (K) | TMR (%) | $V_c$ (mV) | | $\tau_o$ (ns) | | $E$ (fJ) | |
|---|---|---|---|---|---|---|---|
| | | AP→P | P→AP | AP→P | P→AP | AP→P | P→AP |
| 4 | 200 | 399 | 421 | 0.94 | 1.03 | 103 | 286 |
| 75 | 193 | 393 | 416 | 0.94 | 1.05 | 98 | 283 |
| 150 | 182 | 381 | 403 | 0.96 | 1.10 | 94 | 287 |
| 295 | 117 | 225 | 305 | 1.48 | 1.38 | 51 | 195 |

Une faible consommation d'énergie est une exigence nécessaire pour minimiser le coût de la puissance de refroidissement et pour obtenir une stabilité thermique satisfaisante compte tenu de la faible capacité thermique des matériaux à basse température.

Une méthode de contrôle de l'anisotropie magnétique par une tension électrique, dite VCMA pour "voltage-controlled magnetic anisotropy" en anglais, est proposée [T. Nozaki et al. "Recent progress in the voltage-controlled magnetic anisotropy effect and the challenges faced in developing voltage-torque MRAM", Micromachines 10(5):327, 2019] comme nouveau mécanisme d'écriture pour les mémoires magnétiques de type MRAM à température ambiante (de l'ordre de 300 K). Cette méthode permet une réduction spectaculaire de la consommation d'énergie d'écriture, tout en utilisant des combinaisons de matériaux conventionnellement utilisés dans la réalisation de jonction tunnel magnétique et permettant d'obtenir un rapport de magnétorésistance tunnel élevé. La VCMA consiste en une variation de l'anisotropie magnétique qui existe à l'interface entre une électrode magnétique métallique, par exemple en CoFeB, et une barrière tunnel, par exemple en MgO. La variation d'anisotropie magnétique est induite par l'application d'une tension de polarisation à travers la barrière tunnel. L'anisotropie peut être augmentée ou diminuée en fonction de la polarité de la tension appliquée. Aucune circulation de courant à travers la jonction tunnel magnétique n'est nécessaire pour mettre en œuvre la VCMA. La consommation de puissance nécessaire pour retourner l'aimantation d'une couche libre est réduite par rapport à la consommation de puissance nécessaire pour retourner l'aimantation d'une mémoire magnétique nécessitant la circulation d'un courant. Dans ce dernier cas, l'accroissement de puissance est notamment dû à la dissipation ohmique par effet Joule. Le principe de la VCMA est illustré par la figure 2a. Une aimantation est représentée par une flèche sur une sphère unité et par une boule dans un paysage énergétique représentant l'anisotropie magnétique. Ce paysage énergétique dépend de la tension V appliquée à la jonction tunnel. Lorsque la boule est dans un puit du paysage énergétique, l'aimantation est alignée selon une orientation stable. Les puits du paysage énergétique correspondent aux orientations stables de l'aimantation dans l'espace réel en l'absence de tension appliquée. Dans ce cas, les puits sont séparés par une barrière énergétique. L'application d'une tension électrique aux bornes de la jonction tunnel magnétique permet, lorsqu'elle est correctement polarisée, de modifier l'anisotropie magnétique, abaissant notablement la barrière énergétique entre les deux puits, c'est-à-dire la barrière séparant les deux orientations stables de l'aimantation. Ceci permet dynamiquement à la boule de passer d'un puit d'énergie à l'autre réalisant ainsi une commutation de l'aimantation. Lors de cette commutation, l'aimantation réalise un mouvement de précession. Cela permet ainsi de retourner l'aimantation en utilisant une impulsion de tension dont la polarité et l'amplitude permettent d'abaisser suffisamment la barrière énergétique. De plus, une durée d'impulsion correspondant à environ la moitié de la période de précession de l'aimantation est suffisante pour réaliser le retournement de l'aimantation.

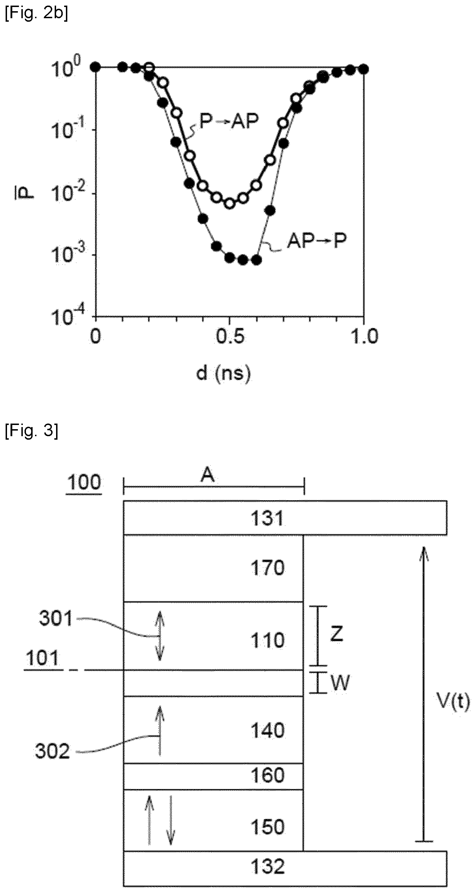

[C. Grezes et al. "Write error rate and read disturbance in electric-field-controlled magnetic-random-access memory", IEEE Magn. Lett. 8, 2017] divulgue un exemple de retournement de l'aimantation d'une jonction tunnel magnétique perpendiculaire configurée pour mettre en œuvre la VCMA. La jonction tunnel magnétique perpendiculaire comprend notamment une électrode métallique magnétique en CoFeB et une barrière tunnel en MgO. Le retournement de l'aimantation est obtenu à température ambiante par VCMA grâce à une impulsion de 500 ps et une énergie totale consommée de 6 fJ/bit. L'énergie consommée est nettement inférieure à l'énergie consommée par un dispositif contrôlé par transfert de spin. [T. Yamamoto et al. "Improvement of write error rate in voltage-driven magnetization switching", J. Phys. D Appl. Phys. 52, 164001, 2019] divulgue que le taux d'erreur d'écriture peut être inférieur à $10^{-6}$. Toutefois, le retournement par VCMA nécessite un contrôle de la durée de l'impulsion de l'ordre de quelques dizaines de picosecondes, illustré par la figure 2b, contrôle difficilement réalisable sur une puce électronique.

Il existe donc un besoin de fournir un dispositif magnétique permettant de stocker une information qui soit notamment compatible avec un environnement cryogénique.

## RÉSUMÉ DE L'INVENTION

L'invention permet de réduire la consommation énergétique nécessaire en particulier à l'écriture d'une information binaire dans un support de stockage. De plus, elle permet d'offrir un temps effectif de rétention de l'information important pouvant être supérieur à environ 10 ans dans un fonctionnement à température cryogénique, ce qui correspond aux attentes en termes de non-volatilité dans le domaine du stockage d'information. L'invention permet également de réduire la contrainte sur le contrôle de la durée de l'impulsion électrique nécessaire pour réaliser l'écriture de l'information binaire. Pour ces raisons, l'invention fournit un moyen de stocker une information qui est compatible avec un environnement cryogénique.

L'invention concerne un dispositif magnétique cryogénique contrôlé en tension comportant :

- une première couche magnétique, dite couche libre, s'étendant suivant un plan de référence et présentant une première aimantation, dite aimantation libre, et une anisotropie magnétique favorisant l'orientation de l'aimantation libre selon une première orientation ou une deuxième orientation, la première orientation comprenant une première composante perpendiculaire au plan de référence et la deuxième orientation comprenant une deuxième composante perpendiculaire au plan de référence, la première composante perpendiculaire et la deuxième composante perpendiculaire étant de signes opposés, l'anisotropie magnétique étant définie par une barrière énergétique séparant la première orientation et la deuxième orientation, l'amplitude de la barrière énergétique étant inférieure à 6300 $k_B$, la couche libre présentant un facteur d'amortissement de Gilbert compris entre 0,02 et 0,4 ;

- une deuxième couche isolante non-magnétique, dite barrière tunnel, s'étendant au contact de la couche libre ; et

- un moyen configuré pour appliquer une impulsion de tension à travers la barrière tunnel, ladite impulsion de tension étant adaptée pour réduire l'amplitude de la barrière énergétique et commuter l'aimantation libre de :

- la première orientation à la deuxième orientation ; ou de

- la deuxième orientation à la première orientation.

On entend par le terme commutation, le changement d'orientation de l'aimantation libre passant d'une orientation stable à une autre orientation stable. On utilisera indifféremment les termes commutation, basculement, retournement ou renversement.

On entend par dispositif cryogénique, un dispositif adapté pour une utilisation à une température cryogénique. On entend d'ailleurs par température cryogénique, une température inférieure à 150 K et plus particulièrement une température inférieure ou égale à la température d'ébullition de l'azote sous conditions standard (environ 77 K) ou encore inférieure ou égale à la température d'ébullition de l'hélium sous conditions standard (environ 4 K).

$k_B$ est la constante de Boltzmann.

Sauf mention contraire, le terme "aimantation" renvoie à l'aimantation libre de la couche libre.

L'état du dispositif magnétique cryogénique correspond à l'orientation de l'aimantation de la couche libre. Par exemple lorsque l'aimantation est alignée selon la première orientation, l'état est "0" et lorsque l'aimantation est alignée selon la deuxième orientation, l'état est "1". Ainsi, le dispositif magnétique cryogénique offre un moyen d'écrire et de stocker un état ou une information binaire.

L'anisotropie magnétique définit un paysage énergétique dans lequel évolue l'aimantation. Les première et deuxième orientations correspondent à des puits au sein de ce paysage énergétique séparés par la barrière énergétique. La barrière énergétique permet de réduire la probabilité que l'aimantation passe d'une orientation à une autre, c'est à dire d'un puits à un autre. Toutefois, une barrière ayant une amplitude élevée rend plus difficile le changement d'orientation de l'aimantation. Il est ainsi nécessaire de fournir une plus grande quantité d'énergie pour procéder au retournement de l'aimantation. Imposer une amplitude limitée à la barrière énergétique permet de limiter la hauteur de la barrière énergétique et donc d'assurer un retournement aisé de l'aimantation. De la sorte, la quantité d'énergie nécessaire au retournement de l'aimantation est réduite. La réduction de la hauteur de la barrière est d'autant plus intéressante que le dispositif est mis en œuvre au sein d'un environnement cryogénique, l'activation thermique y étant fortement réduite par rapport à un environnement à température ambiante.

L'amplitude de la barrière énergétique limitée à 6300 $k_B$ permet d'obtenir une durée de rétention d'au moins 10 ans lorsque le dispositif magnétique est opéré à une température cryogénique.

L'écriture d'un état ou d'une information binaire au sein du dispositif magnétique cryogénique met en œuvre le contrôle de l'anisotropie par la tension (dit VCMA pour "Voltage Control of Magnetic Anisotropy" en anglais). Selon la polarité de l'impulsion de tension électrique appliquée à travers la barrière tunnel, le paysage énergétique correspondant à l'anisotropie magnétique est modifié et la barrière énergétique peut être augmentée ou réduite. La modification du paysage énergétique entraine l'aimantation dans un mouvement de précession. Lorsque la polarité de l'impulsion est configurée pour réduire l'amplitude de la barrière énergétique, alors le mouvement de précession peut emmener l'aimantation à dépasser la barrière énergétique et ainsi changer de puits, c'est à dire réaliser une commutation.

Ainsi, grâce à l'amplitude limitée de la barrière énergétique, à la modulation de l'amplitude de la barrière énergétique par une impulsion de tension et au mouvement de précession qui en découle, l'aimantation est en mesure de réaliser une commutation ne requérant qu'une quantité d'énergie réduite. Le dispositif magnétique cryogénique est donc compatible avec les exigences qu'impose un environnement cryogénique.

Outre les caractéristiques qui viennent d'être évoquées dans les paragraphes précédents, le dispositif magnétique cryogénique selon l'invention peut présenter une ou plusieurs caractéristiques complémentaires parmi les suivantes, considérées individuellement ou selon toutes les combinaisons techniquement possibles :

- le facteur d'amortissement de Gilbert de la couche libre est compris entre 0,05 et 0,3 et préférentiellement entre 0,1 et 0,3 ;

- le dispositif magnétique cryogénique comprend une troisième couche magnétique et conductrice, dite couche de référence, s'étendant au contact de la barrière tunnel et présentant une deuxième aimantation, dite aimantation de référence, fixe et sensiblement perpendiculaire au plan de référence ;

- la couche de référence est apte à transmettre les impulsions de tension à la barrière tunnel ;

- la couche libre présente une première épaisseur choisie pour que l'amplitude de la barrière énergétique soit inférieure à 6300 $k_B$ ;

- la couche libre présente une anisotropie magnétique telle que la première orientation et la deuxième orientation appartiennent à :

- un axe facile, sensiblement perpendiculaire au plan de référence ; ou

- un cône facile, l'axe du cône facile étant sensiblement perpendiculaire au plan de référence ;

- le dispositif magnétique cryogénique comporte un moyen pour appliquer un champ magnétique planaire au niveau de la couche libre, au moins pendant la durée d'application de l'impulsion de tension, ledit champ magnétique planaire étant sensiblement contenu à l'intérieur du plan de référence ;

- le dispositif magnétique cryogénique comprenant une couche antiferromagnétique adaptée pour appliquer une anisotropie d'échange au niveau de la couche libre ;

- la couche libre présente une anisotropie comprenant une composante uniaxiale sensiblement contenue à l'intérieur du plan de référence ;

- la couche libre présente une structure cristallographique configurée pour induire la composante d'anisotropie uniaxiale sensiblement contenue dans le plan de référence ;

- la couche libre présente une forme d'ellipse dans le plan de référence, le rapport d'aspect de l'ellipse étant de préférence compris entre 1,2 et 3 ;

- la barrière tunnel est choisie telle que le produit de sa résistance par sa surface soit supérieur à $10 \ \Omega \cdot \mu m^2$ et de préférence supérieure à $100 \ \Omega \cdot \mu m^2$;

- la couche libre comprend un alliage à base de Fer, avantageusement à base de Fer et de Cobalt, et un élément amorphisant avantageusement choisi parmi les éléments suivants : Bore, Zirconium, Niobium, Hafnium ou une combinaison de ces éléments amorphisants. Un élément amorphisant permet de donner une structure amorphe à ladite couche libre lors de son dépôt ;

- la couche libre comprend des impuretés présentant un fort couplage spin-orbite avantageusement choisi parmi les éléments suivants : Dysprosium, Terbium, Platine, Palladium, Or, Iridium, Tungstène, Tantale ou une combinaison de ces éléments ;

- la couche libre comprend une première face, en contact avec la barrière tunnel et une deuxième face, opposée à la première face, en contact avec une couche de lamination ("dusting layer" en anglais) apte à produire une augmentation du facteur d'amortissement de Gilbert, cette couche de lamination comprenant des impuretés présentant un fort couplage spin-orbite avantageusement choisi parmi les éléments suivants : Dysprosium, Terbium, Platine, Palladium, Or, Iridium, Tungstène, Tantale ou une combinaison de ces éléments ;

- l'impulsion de tension comprend :

  - une première polarité configurée pour réduire l'amplitude de la barrière énergétique, de durée et d'amplitude choisies pour commuter l'aimantation libre ; et

  - une deuxième polarité opposée à la première polarité et configurée pour augmenter l'amplitude de la barrière énergétique, de durée et d'amplitude choisies pour permettre la lecture de l'état magnétique de la couche libre.

Par "appartient à un cône facile", on entend appartient à la paroi dudit cône facile.

L'invention et ses différentes applications seront mieux comprises à la lecture de la description qui suit et à l'examen des figures qui l'accompagnent.

## BRÈVE DESCRIPTION DES FIGURES

Les figures sont présentées à titre indicatif et nullement limitatif de l'invention.

[Fig. 1a] représente schématiquement une première mémoire magnétique selon l'art antérieur.

[Fig. 1b] représente schématiquement un taux d'erreur de commutation d'une deuxième mémoire magnétique selon l'art antérieur.

[Fig. 1c] représente schématiquement une probabilité de commutation d'une aimantation d'un état parallèle à antiparallèle et d'un état antiparallèle à parallèle d'une troisième mémoire magnétique selon l'art antérieur.

[Fig. 2a] représente schématiquement un principe de contrôle de l'anisotropie magnétique par une tension électrique.

[Fig. 2b] représente schématiquement un taux d'erreur de commutation d'une quatrième mémoire magnétique selon l'art antérieur.

[Fig. 3] représente schématiquement un mode de réalisation d'un dispositif magnétique cryogénique selon l'invention.

[Fig. 4a] représente schématiquement un premier exemple d'anisotropie magnétique du dispositif magnétique cryogénique selon l'invention.

[Fig. 4b] représente schématiquement un deuxième exemple d'anisotropie magnétique du dispositif magnétique cryogénique selon l'invention.

[Fig. 4c] représente schématiquement un troisième exemple d'anisotropie magnétique du dispositif magnétique cryogénique selon l'invention.

[Fig. 5] représente schématiquement un effet de l'application d'une tension électrique à travers le dispositif magnétique cryogénique selon l'invention.

[Fig. 6] représente schématiquement un modèle numérique correspondant au dispositif magnétique cryogénique selon l'invention.

[Fig. 7], [Fig. 8], [Fig. 9], [Fig. 10] présentent des premiers résultats de simulation numérique du modèle numérique de la figure 6.

[Fig. 11a] et [Fig. 11b] représentent schématiquement des première et deuxième trajectoires suivies séquentiellement par l'aimantation du modèle numérique de la figure 6 lors de la commutation mettant en œuvre le contrôle de l'anisotropie magnétique par une tension électrique.

[Fig. 12], [Fig. 13a], [Fig. 13b], [Fig. 14a], [Fig. 14b], [Fig. 15a], [Fig. 15b], [Fig. 15c], [Fig. 15d], [Fig. 15e] et [Fig. 16] présentent des deuxièmes résultats de simulation numérique du modèle numérique de la figure 6.

Sauf précision contraire, un même élément apparaissant sur des figures différentes présente une référence unique. Les figures sont présentées à titre indicatif et nullement limitatif de l'invention.

## DESCRIPTION DÉTAILLÉE

La figure 3 montre une représentation schématique d'un mode de réalisation d'un dispositif magnétique cryogénique 100 selon l'invention. Le dispositif 100 peut former une mémoire magnétique de type MRAM comprenant une jonction tunnel magnétique.

Le dispositif 100 comprend une première couche 110 magnétique, dite couche libre, s'étendant le long d'un plan 101 de référence que l'on appellera également plan des couches. La couche libre 110 présente une anisotropie $\varepsilon$ magnétique et une première aimantation 301 que l'on appellera aimantation libre.

Une deuxième couche 120 isolante et non-magnétique, dite barrière tunnel, s'étend au contact de la couche libre 110.

Une troisième couche 140 magnétique, dite couche de référence, s'étend au contact de la barrière tunnel 120. La couche de référence 140 présente une deuxième aimantation 302 que l'on appellera également aimantation de référence, figée sensiblement perpendiculairement au plan de référence 101.

Une quatrième couche 150 antiferromagnétique ou dite antiferromagnétique synthétique est magnétiquement couplée avec la couche de référence 140, permettant de figer l'aimantation de référence 302.

Un moyen 131, 132 configuré pour appliquer une tension électrique $V(t)$ à travers la barrière tunnel 120. Le moyen 131, 132 comprend deux parties 131, 132 en contact avec l'empilement comprenant les quatre couches précitées permet l'application de la tension $V(t)$ sur l'empilement et plus particulièrement aux bornes de la barrière tunnel 120, c'est à dire à travers la barrière tunnel 120. Par "à travers la barrière tunnel", on entend dans l'épaisseur de la barrière tunnel 120. Le moyen peut comprendre des électrodes conductrices, par exemple en Cuivre Cu. Le moyen 131, 132 peut également comprendre la couche libre 110 et la couche de référence 140. Pour cela, les couches libre 110 et de référence 140 sont préférentiellement conductrices afin de permettre la transmission de la tension électrique *V(t)* sur la barrière tunnel 120.

La couche libre 110 peut être réalisée à partir d'un alliage comprenant du Fer et avantageusement un alliage de Cobalt et de Fer, tels que l'alliage le CoFe ou le CoFeB.

La couche libre peut également comprendre des éléments amorphisants. Les éléments amorphisants sont connus de la personne du domaine pour donner une structure amorphe lors du dépôt de la couche libre 110 et permettre une recristallisation selon une structure cubique centré lors d'un recuit postérieur au dépôt. La structure cubique centré, dite BCC pour "body-centered cubic" en anglais, permet d'obtenir une forte amplitude de magnétorésistance tunnel lorsque la couche libre 110 est combinée avec une barrière tunnel 120 à base de MgO. Les éléments amorphisants sont avantageusement choisis parmi : le bore B, le zirconium Zr, le niobium Nb et le hafnium Hf ou une combinaison de ces éléments. Les éléments amorphisants peuvent avantageusement être choisis parmi tous les éléments ou combinaison d'éléments présentant les avantages précités.

La couche libre 110 peut également comprendre des éléments magnétiques tels que le nickel Ni ou non-magnétiques tels que le carbone C.

Lorsque le dispositif 100 est opéré à température cryogénique, notamment inférieure à 20 K, alors la couche libre 110 peut avantageusement comprendre des matériaux présentant une température de Curie basse, par exemple inférieure à 473 K (200 °C). Des matériaux présentant une température de Curie inférieure à la température ambiante peuvent également être envisagés. Il peut par exemple s'agir d'alliage de Heusler tels que le $Co_2MnSi$, le $Co_2Mn_{1.29}Al$, le $Co_2FeAl_{0.5}Si_{0.5}$, le $Co_2FeAl$, le $Co_2Cr_{0.6}Fe_{0.4}Al$ ou encore le $Co_2Fe_{0.4}Mn_{0.6}Si$. Ces matériaux permettent d'obtenir une amplitude du signal de magnétorésistance tunnel élevée. Par exemple, l'alliage $Co_2MnSi$ permet d'obtenir un signal de magnétorésistance de l'ordre de 1995 % à 4,2 K.

La barrière tunnel 120, peut être réalisée à partir d'oxyde, de nitrure ou d'une combinaison d'oxydes et de nitrures. Par exemple, il peut s'agir de MgO, de $MgAl_xO_y$, de $AlO_x$, de TiOx, de HfOx, de TaOx, de AlN, de BN ou de TiN.

La couche de référence 140 peut être réalisé à partir des mêmes matériaux que la couche libre 110, tels que le CoFeB. La couche de référence 140 peut avantageusement présenter une épaisseur comprise entre 1 nm et 1,4 nm. En plus des éléments précités, la couche de référence 140 peut également comprendre, au même titre que la couche libre 110, des éléments magnétiques tels que le Ni, non-magnétiques tels que le C, des terres-rares ou encore des éléments amorphisants. La quatrième couche 150 antiferromagnétique comprend préférentiellement deux sous-couches ferromagnétiques séparées par une sous-couche d'espacement, les deux sous-couches ferromagnétiques étant couplées de telle manière que leurs aimantations respectives s'alignent de manière antiparallèle à travers la sous-couche d'espacement. On parle dans ce cas de couche antiferromagnétique synthétique ou de couche SAF pour "Synthetic AntiFerromagnetic layer" en anglais. Les deux sous-couches ferromagnétiques comprennent préférentiellement du Co, du Pt, du Ni ou des multicouches comprenant ces éléments, comme : $Co_x/Pt_y$, $Co_x/Pd_y$, ou $Co_x/Ni_y$. Le couplage magnétique entre les deux sous-couches ferromagnétiques, qui peut être un couplage d'échange tel que le couplage de Ruderman-Kittel-Kasuya-Yoshida dit "RKKY", dépend directement de la nature de la sous-couche d'espacement, par exemple en Ruthénium Ru, et de son épaisseur, que l'on choisira préférentiellement entre 0,4 nm et 0,9 nm dans le cas du Ruthénium.

La couche SAF 150, couplée avec la couche de référence 140, renforce l'anisotropie magnétique de cette dernière, permettant de figer la direction de l'aimantation de référence hors du plan de référence 101.

Les structures cristallines de la couche SAF 150, par exemple cubique face centrée, et de la couche de référence 140, par exemple cubique centrée, peuvent être adaptées l'une à l'autre au moyen d'une cinquième couche 160 métallique et non-magnétique dite couche de transition structurale. La couche de transition structurale 160 est caractérisée par son épaisseur, comprise entre 0,2 nm et 0,4 nm, et sa composition, comprenant avantageusement du Tantale Ta, du Tungstène W ou du Molybdène Mo. La couche de transition 160 permet également d'absorber les éléments amorphisants issus de la couche de référence 140 lors du recuit post-dépôt du dispositif 100.

Les épaisseurs respectives de la couche de référence 140, de la couche SAF 150 et de la couche de transition 160, sont préférentiellement configurées en fonction de l'aimantation des différentes couches magnétiques 140 et de SAF 150, afin de limiter leurs champs de fuite au niveau de la couche libre 110. Ainsi, l'orientation relative de l'aimantations libre par rapport à l'aimantation de référence, qu'elle soit parallèle ou antiparallèle, n'est pas favorisée dans une direction ou l'autre par lesdits champs de fuite.

Le dispositif 100 comprend avantageusement une couche tampon (« buffer layer » en anglais), non-représentée sur la figure 3, permettant une bonne croissance des différentes couches, c'est-à-dire avec une rugosité efficace, avantageusement inférieure à 0.4 nm et une bonne texture. La couche tampon peut comprendre du Platine Pt et présenter une épaisseur de 3 nm. Le dispositif 100 peut également comprendre une couche de mouillage, non-représentée sur la figure 3, comprenant du Tantale Ta et présentant une épaisseur de l'ordre de 3 à 6 nm. Cette couche de mouillage est utilisée par exemple pour favoriser l'adhérence du dépôt sur un substrat d'oxyde.

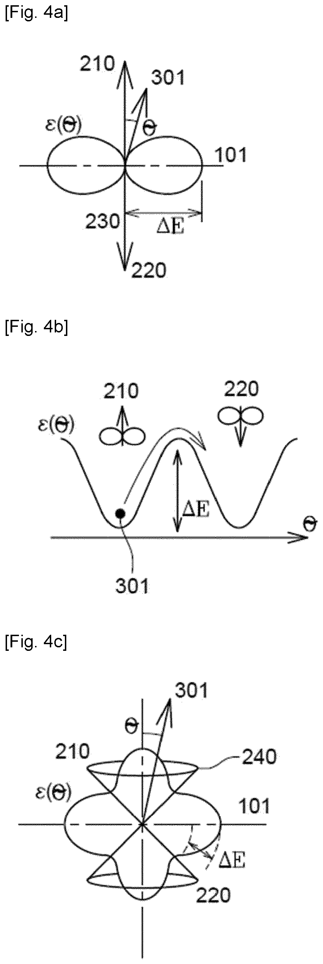

Un premier exemple d'anisotropie magnétique $\varepsilon$ du dispositif magnétique est représenté dans la figure 4a. Il correspond à une anisotropie magnétique $\varepsilon$ dans lequel un terme d'anisotropie du premier ordre, également appelé terme d'anisotropie uniaxiale, est dominant. Elle s'exprime ainsi selon la relation

[Math. 1]

$$\varepsilon(\theta) = K_1 \sin^2(\theta)$$

où $K_1 > 0$ est le coefficient d'anisotropie du premier ordre et $\theta$ est l'angle entre l'aimantation libre 301 et la normale au plan de référence 101. L'anisotropie $\varepsilon$ est maximale lorsque l'aimantation 301 est dans le plan de référence 101 et minimale lorsque l'aimantation 301 est perpendiculaire au plan de référence 101. L'orientation vers laquelle l'aimantation 301, en l'absence de champ extérieur, tend à s'orienter forme un axe 230 perpendiculaire au plan de référence 101, qu'on appelle axe facile.

L'axe facile 230 induit une première orientation 210 stable et une deuxième orientation 220 stable vers lesquels l'aimantation libre tend à s'orienter 301. La première orientation 210 correspond à un premier sens le long de l'axe facile 230 et la deuxième orientation 220 correspond à un deuxième sens, opposé au premier sens, le long de l'axe facile 230. Autrement dit, la première orientation 210 et la deuxième orientation 220 comprennent chacune une composante perpendiculaire au plan de référence 101, leurs composantes perpendiculaires respectives étant de signes opposés. Les deux orientations 210, 220 correspondent aux états "haut" ou "bas", ou encore les états "0" ou "1", du dispositif magnétique. La commutation du dispositif revient donc à faire passer l'aimantation libre de la première orientation 210 à la deuxième orientation 220 ou *vice-versa*.

Les première et deuxième orientations 210, 220 sont séparées par une barrière énergétique $\Delta E$, que l'on appellera également barrière de potentiel ou barrière d'anisotropie, réduisant la probabilité que l'aimantation libre 301 ne passe de manière incontrôlée de la première orientation 210 à la deuxième orientation 220 et *vice-versa*.

Des termes d'anisotropie d'ordre supérieur, par exemple d'origine magnétocristalline, peuvent apparaître dans l'expression de l'anisotropie $\varepsilon$, modifiant la forme de l'anisotropie totale. Par exemple, une anisotropie d'interface entre la couche libre et la barrière tunnel peut comporter des termes d'anisotropie d'ordre supérieur qui viennent s'ajouter à l'anisotropie de la couche libre. La rugosité, les variations de composition ou encore les variations d'épaisseur de la couche libre peuvent également induire des termes d'anisotropie d'ordre supérieur.

La figure 4a représente schématiquement l'anisotropie magnétique $\varepsilon(\theta)$ de la couche libre en fonction de l'angle $\theta$. L'anisotropie magnétique $\varepsilon(\theta)$ correspond à un paysage énergétique dans lequel l'aimantation libre 301, représentée par une boule, se déplace. Les orientations stables 210, 220 correspondent chacune à un puit du paysage énergétique. Une barrière d'anisotropie de hauteur $\Delta E$ sépare ces deux puits.

La couche libre présente une stabilité thermique caractérisée par un temps de rétention $\tau$ donné par la loi d'Arrhenius :

[Math. 2]

$$\tau = \tau_0 exp\left(\frac{\Delta E}{k_B T}\right)$$

où $\Delta E$ est la hauteur, ou amplitude, de la barrière énergétique séparant les deux orientations 210, 220 et $\tau_0$ est le temps caractéristique entre deux tentatives de commutation, appelé « temps d'essai », typiquement de l'ordre d'une nanoseconde. On obtient ainsi un facteur de stabilité thermique $\Delta$:

[Math 3]

$$\Delta = \frac{\Delta E}{k_B T}$$

Si elle devient non négligeable par rapport à la hauteur de barrière énergétique, l'énergie d'activation thermique $k_B T$ peut provoquer une commutation fortuite du dispositif, c'est à dire le passage de l'aimantation libre 301 d'un puit à l'autre, impliquant une perte de l'information stockée au sein du dispositif. La probabilité $\overline{P}$ de ne pas observer un retournement dû à l'activation thermique après un temps $t$ est donnée par :

[Math. 4]

$$\overline{P} = \exp\left(\frac{-t}{\tau}\right)$$

Afin de prévenir le retournement intempestif de l'aimantation libre 301 et assurer un stockage de l'information pérenne, la hauteur de barrière $\Delta E$ doit être ajustée. Par exemple, un temps de rétention $\tau$ de l'ordre de 10 ans correspond à une hauteur $\Delta E$ de barrière égale à :

[Math. 5]

$$\Delta E = K_{eff}Az = k_B T \ln\left(\frac{\tau}{\tau_0}\right) \sim 40\,k_B T$$

où $K_{eff}$ est le coefficient d'anisotropie effectif de la couche libre et où $A$ et $z$ sont respectivement la surface et l'épaisseur de la couche libre. À température ambiante (environ 300 K), l'énergie d'activation thermique est élevée, environ $300k_B$ (où $k_B$ est la constante de Boltzmann).

Le couplage des atomes de fer de la couche libre avec les atomes d'oxygène ou d'azote de la barrière tunnel induit un terme d'anisotropie perpendiculaire à l'interface, dit également "anisotropie d'interface". Les alliages de Heusler présentent également un intérêt pour obtenir une anisotropie d'interface. Certains alliages de Heusler, comprenant notamment du fer tels que l'alliage de $Co_2FeAl$, permettent d'obtenir une anisotropie perpendiculaire à l'interface avec la barrière tunnel comprenant par exemple du MgO.

L'anisotropie magnétique totale, ou effective, de la couche libre comprend le terme d'anisotropie d'interface entre la couche libre et la barrière tunnel. L'anisotropie d'interface est caractérisée par un coefficient d'anisotropie d'interface $K_s$ exprimée en énergie par unité de surface. À titre d'exemple, pour des couches de CoFeB/MgO, le coefficient d'anisotropie d'interface est d'environ $K_s \sim 1{,}4$ mJ/m$^2$. L'anisotropie magnétique de la couche libre comprend également un terme de champ démagnétisant, résultant par exemple de la forme de la couche libre, d'autant plus important si cette dernière est une couche mince. En négligeant les termes d'anisotropie d'ordre supérieur et d'autres termes possibles d'anisotropie de volume d'origine magnétocristalline ou magnétostrictive, le coefficient d'anisotropie effectif $K_{eff}$ est donné par :

[Math. 6]

$$K_{eff} = \frac{K_s}{z} - \frac{\mu_o M_S^{\,2}}{2}(N_{zz} - N_{xx})$$

où $\mu_o$ est la perméabilité du vide, $M_S$ est l'aimantation à saturation et $N_{xx}$, $N_{yy}$ et $N_{zz}$ sont les composantes du tenseur du champ démagnétisant où $N_{xx} = N_{yy}$ (couche circulaire). La hauteur de la barrière énergétique séparant les première et deuxième orientations 210, 220 peut donc être décrite par :

[Math. 7]

$$\Delta E = K_1 Az = A\left[K_s - \frac{\mu_o M_S^{\,2}}{2}z(N_{zz} - N_{xx})\right]$$

La barrière énergétique disparait ($\Delta E = 0$) pour une épaisseur $z$ de la couche libre définie par :

[Math. 8]

$$z = \frac{2\,K_S}{\mu_0 M_S\,(N_{zz} - N_{xx})}$$

Considérons un dispositif comprenant une anisotropie d'interface $K_S \sim 1,4$ mJ/m$^2$ entre la couche libre et la barrière tunnel et une couche libre dont le diamètre est beaucoup plus grand que l'épaisseur ($N_{zz}$ - $N_{xx} \sim 1$), alors une épaisseur $z_c$ critique, à laquelle l'anisotropie d'interface et le champ démagnétisant se compense, est de 1,4 nm. Lorsque la couche libre présente une épaisseur z inférieure à l'épaisseur critique $z_c$, l'anisotropie $\varepsilon$ résultante est perpendiculaire car dominée par l'anisotropie d'interface. Lorsque la couche libre présente une épaisseur z supérieure à l'épaisseur critique $z_c$, par exemple de l'ordre de 1,5 nm, l'anisotropie $\varepsilon$ résultante est planaire (c'est à dire que les orientations stables appartiennent au plan de référence) car dominée par le champ démagnétisant. L'épaisseur de la couche libre est préférentiellement choisie inférieure à l'épaisseur $z_c$ de sorte que les orientations stables 210, 220 soient hors du plan de référence 101.

L'activation thermique à très basse température, par exemple 3 K, est environ 100 fois inférieure à l'activation thermique à température ambiante, par exemple 300 K. Le rapport des facteurs de stabilité thermique Δ à 3 K et 300 K est :

[Math. 9]

$$\frac{\Delta\,(T = 300)}{\Delta\,(T = 3)} = \frac{K_1 L}{300 k_B}\frac{3 k_B}{K_1 L} = \frac{1}{100}$$

Le facteur de stabilité thermique Δ à 3 K est donc cent fois supérieur au facteur de stabilité thermique à 300 K. Une anisotropie $\varepsilon$ cent fois moindre à basse température (3 K) qu'à 300K suffit donc pour obtenir une durée de rétention de l'ordre de 10 ans.

Suivant la loi d'Arrhenius, la durée de rétention $\tau$ décroît lorsque la température T augmente. Par exemple, une mémoire opérant à température ambiante doit, pour assurer une durée de rétention $\tau$ = 10 ans, présenter une hauteur de barrière énergétique $\Delta E$ :

[Math. 10]

$$\Delta E(\tau = 10\ \text{ans}) = 40\,k_B\,T$$

Pour assurer une durée de rétention de 1s à température ambiante, la hauteur de barrière nécessaire devient :

[Math. 11]

$$\Delta E(\tau = 1\text{s}) = 21\,k_B\,T$$

Une barrière de 14 $K_B\,T$ suffit pour une durée de rétention de 1 ms et 7 $K_B\,T$ pour une durée de rétention de 1 µs. Ce qui signifie qu'à température ambiante $T$ = 300 K, une hauteur de barrière énergétique

[Math. 12]

$$\Delta E(T = 300\ \text{K}) = 6300\,k_B$$

est suffisante pour assurer une durée de rétention de 1 s. Et similairement, une hauteur ∆E = 2100 $k_B$ suffit pour assurer une durée de rétention de 1 µs.

En d'autres mots, réduire la hauteur ∆E de la barrière énergétique à température ambiante 12000$k_B$ à 2100$k_B$ réduit la durée de rétention $\tau$ de 10 ans à 1 µs. En revanche, réduire la hauteur ∆E de barrière énergétique en réduisant la température à $T$ = 52 K permet de conserver une durée de rétention $\tau$ de 10 ans.

Ainsi le dispositif selon l'invention peut être utilisé comme dispositif de stockage non-volatile opérant à température proche de la température ambiante et ne nécessitant qu'une faible durée de rétention, de l'ordre de la seconde ou de la milliseconde, tels que les mémoires statiques à accès aléatoire non-volatiles, dites mémoires SRAM non-volatiles, ou les mémoires FIFO (pour "First In, First Out" en anglais) ou comme dispositif de stockage présentant une plus longue rétention fonctionnant à température cryogénique.

La mise en œuvre d'une barrière énergétique de hauteur ∆E = 6300 $k_B$ à basse température permet ainsi la mise en œuvre aisé du retournement par contrôle de l'anisotropie par une tension (VCMA) par rapport à des hauteurs de barrières de l'art antérieur s'étendant de 60 $k_B T$ (soit 18000 $k_B$ à température ambiante) à 100 $K_B T$ (soit 30000 $k_B$ à température ambiante).

De plus, la mise en œuvre d'une barrière présentant une hauteur réduite permet de réduire la consommation énergétique lors de la phase de commutation. Les mémoires non-volatiles présentent toujours un compromis entre durée de rétention de l'information et la facilité d'écriture de cette information. Une longue durée de rétention de l'information est obtenue moyennant une hauteur de barrière ∆E élevée car il faut alors attendre longtemps une très forte fluctuation thermique capable de dépasser la barrière énergétique pour accidentellement changer l'orientation de l'aimantation de la couche libre. Mais ceci implique aussi que si on veut volontairement changer l'état magnétique de la couche libre lors d'un événement d'écriture, il faut fournir une énergie importante pour passer la barrière énergétique d'où une forte consommation électrique à l'écriture. La réduction de la hauteur de barrière ∆E d'un à deux ordres de grandeur permet de réduire d'autant l'énergie à dépenser pour réaliser la commutation de l'aimantation libre 301 tout en conservant une durée de rétention élevée, de l'ordre de 10 ans, à basse température, de l'ordre de 3 K à 4 K.

L'homme du métier pourra mesurer la hauteur ∆E de la barrière énergétique afin de déterminer sa valeur. Pour cela, l'homme du métier réalisera par exemple une étude de l'évolution de la durée de rétention $\tau$ du dispositif en fonction de la température $T$ de manière à obtenir la hauteur ∆E grâce à la relation d'Arrhenius :

[Math. 13]

$$\Delta E = k_B T \ln\left(\frac{\tau}{\tau_0}\right)$$

Une autre méthode connue de l'homme du métier pour déterminer la hauteur de barrière consiste à mesurer la dépendance du courant de commutation de l'aimantation de la couche libre induite par transfert de spin en fonction de la durée des impulsions de courant $\tau_{pulse}$ dans un régime dit activé thermiquement, c'est-à-dire pour des impulsions de courant ayant une durée $\tau_{pulse}$ typiquement entre 20 ns à la milliseconde. Le courant nécessaire à la commutation magnétique de la couche douce varie alors comme

$$I = I_0 \left(1 - \frac{1}{\Delta}\ln\left(\frac{\tau_{pulse}}{\tau_0}\right)\right)$$

où $I_0$ est une constante correspondant au courant minimum de commutation requis pour commuter au bout d'un temps infini à $T$ = 0 K. La pente de la variation linéaire du courant d'écriture $I$ en fonction de $\ln\left(\frac{\tau_{pulse}}{\tau_0}\right)$ permet de déterminer le facteur de stabilité thermique ∆ et donc la hauteur de barrière ∆E.

À la différence de l'exemple illustré par les figures 4a et 4b, l'anisotropie ε représentée dans la figure 4c, comprend des termes d'anisotropie d'ordre un et deux et peut s'exprimer de la façon suivante :

[Math. 14] $\quad \varepsilon = K_1 \sin^2(\theta) + K_2 \sin^4(\theta)$

où $K_2$ est le coefficient d'anisotropie du second ordre. L'anisotropie résultante est perpendiculaire si les deux conditions suivantes sont satisfaites :

[Math. 15]

$$\begin{cases} K_1 > 0 \\ K_2 > 0 \ \text{ou} \ \dfrac{|K_2|}{K_1} < \dfrac{1}{2} \end{cases}$$

Lorsque $K_2 < 0$ et $|K_2|K_1 > 1/2$ alors l'anisotropie $\varepsilon$ est maximale lorsque l'aimantation 301 est dans le plan de référence 101 ou perpendiculaire au plan de référence 101. En revanche, l'anisotropie est minimale pour un angle $\theta_c$ intermédiaire :

[Math. 16]

$$\cos^2 \theta_c = \frac{-K_1}{2K_2}$$

Ainsi, l'orientation vers laquelle l'aimantation 301 tend à s'orienter, en l'absence de champ extérieur, appartient à un cône 240, que l'on appelle cône facile, caractérisé par un angle d'ouverture $\theta_c$ et un axe perpendiculaire au plan de référence 101.

Il est connu dans le domaine du magnétisme que l'orientation stable vers laquelle tend l'aimantation sous l'effet de la seule anisotropie de cône facile appartient à la paroi du cône facile et non pas l'intérieur du cône facile. On entend donc par "appartient au cône facile", appartient à la paroi du cône facile.

Les première et deuxième orientations 210, 220 stables appartiennent à la paroi du cône facile 240 et de la même manière que l'exemple illustré par la figure 4a, les composantes perpendiculaires au plan de référence 101 des première et deuxième orientations 210, 220 sont de signes opposés.

L'anisotropie $\varepsilon$ dépend de l'épaisseur z de la couche libre. Comme décrit par l'équation [Math. 7], l'épaisseur de la couche libre va directement influencer le terme d'anisotropie d'ordre un via l'anisotropie de forme qui est une anisotropie de volume donc proportionnelle à l'épaisseur de la couche. Tant que l'épaisseur est inférieure à une certaine valeur critique telle que les inégalités décrites par [Math. 15] sont satisfaites, alors l'aimantation de la couche libre va rester à l'équilibre perpendiculaire au plan des couches. Au contraire, si l'épaisseur de la couche libre dépasse cette valeur critique alors la condition $|K_2|K_1 > 1/2$ devient satisfaite et alors en présence d'un terme d'anisotropie d'ordre deux $K_2 < 0$, l'aimantation de la couche libre pointe le long d'un cône d'anisotropie facile dont l'angle d'ouverture est donné par [Math. 16].

Le terme d'anisotropie d'ordre deux qui permet de réaliser $K_2 < 0$ et donne lieu à une anisotropie de cône facile peut provenir de la rugosité à la surface de la couche libre au contact de la barrière tunnel. Des techniques telles que l'irradiation ionique peuvent être utilisées pour adapter ce terme d'anisotropie d'ordre deux et sont décrites plus en détail par [Teixeira, B. M. S.; et al, "Ion irradiation-induced easy-cone anisotropy in double-MgO free layers for perpendicular magnetic tunnel junctions", Appl. Phys. Lett.112, 202403, 2018].

Lorsque le coefficient d'anisotropie d'ordre deux est négatif, conduisant à l'apparition d'une anisotropie de cône facile 240, la hauteur $\Delta E$ de la barrière énergétique est réduite par rapport au cas où l'anisotropie d'ordre deux est nulle.

En considérant une hauteur $\Delta E_1$ de la barrière énergétique due au terme d'anisotropie d'ordre un (cas de la figure 4b), alors la hauteur $\Delta E_2$ de la barrière énergétique séparant les orientations stables 210, 220, est donnée par :

[Math. 17]

$$\Delta E_2 = \Delta E_1 \left( 1 - \frac{|K_2|}{K_1} \right)$$

lorsque $|K_2|/K_1 < 1/2$ et

[Math. 18]

$$\Delta E_2 = \frac{\Delta E_1 K_1}{4|K_2|}$$

lorsque $|K_2|/K_1 > 1/2$. Ainsi, lorsque l'anisotropie $\varepsilon$ présente un cône facile 240, la hauteur effective de la barrière énergétique est réduite, facilitant la commutation de l'aimantation libre 301 et réduisant la consommation énergétique nécessaire à ladite commutation. De plus, l'existence d'un angle initial entre la normale au plan des couches et la direction de l'aimantation permet de réduire la stochasticité de la commutation lors de l'écriture de l'état magnétique de la couche libre.

En revanche, lorsque l'anisotropie $\varepsilon$ est du type anisotropie de cône facile 240, le signal de magnétorésistance tunnel que l'on peut obtenir est légèrement réduit. En effet, l'aimantation libre 301 est alors légèrement inclinée par rapport à l'aimantation de référence. Toutefois, la réduction de l'amplitude du signal de magnétorésistance tunnel est fonction du cosinus de l'angle relatif entre ces deux aimantations. Ainsi, si le cône facile 240 présente une ouverture modérée, par exemple, $\theta < 45°$, alors la réduction d'amplitude du signal de magnétorésistance tunnel reste faible. Par exemple, lorsque le cône facile 240 présente un angle d'ouverture de $\theta = 20°$, l'amplitude du signal de magnétorésistance est réduite de 200 % à 177 %, soit une réduction de 12 % en valeur relative (c'est à dire (200%-177%)/200%).

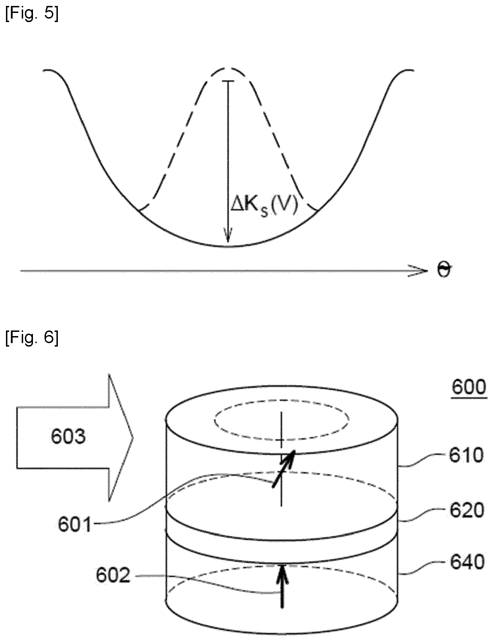

La figure 5 représente schématiquement l'effet de l'application d'une tension V(t) à travers la barrière tunnel. Lorsqu'une tension électrique est appliquée à travers la barrière tunnel, le champ électrique produit modifie l'anisotropie d'interface qui existe entre la couche libre et la barrière tunnel d'une quantité $\Delta K_s(V)$ ayant pour effet de modifier l'anisotropie totale de la couche libre. Cet effet est appelé contrôle de l'anisotropie magnétique par une tension ou VCMA pour "Voltage-Controlled Magnetic Anisotropy" en anglais. La VCMA permet de réduire la hauteur de la barrière énergétique séparant les puits associés aux orientations stables. Ainsi, grâce à la VCMA, l'aimantation libre peut passer d'un puit à l'autre, impliquant la commutation de ladite aimantation.

L'influence du champ électrique sur le terme d'anisotropie d'ordre un de l'anisotropie d'interface est généralement plus élevé que sur les termes d'anisotropie d'ordre supérieur. Pour des raisons de simplicité, nous détaillerons l'action de la VCMA uniquement sur le terme d'anisotropie d'ordre un de l'anisotropie d'interface. Toutefois, les conclusions restent inchangées même en prenant en compte les termes d'anisotropie d'ordre supérieur.

La variation $\Delta K_S(V)$ de l'anisotropie d'interface peut être positive ou négative selon la polarité de la tension électrique V appliquée. L'écriture d'un état d'aimantation au sein du dispositif magnétique est donc réalisée moyennant une impulsion de tension dont la polarité est configurée pour réduire la hauteur de la barrière d'anisotropie. La hauteur $\Delta E$ de la barrière énergétique en fonction de la variation $\Delta K_S$ de l'anisotropie d'interface s'exprime donc comme :

[Math. 19]

$$\Delta E(V) = K_{eff}(V)\, z\, A$$

où $K_{eff}(V)$ est le coefficient d'anisotropie effective d'ordre un, fonction de la tension électrique V, où A est la surface de la couche libre et z est l'épaisseur de la couche libre. Ainsi :

[Math. 20]

$$\Delta E(V) = A\left[K_s + \Delta K_s(V) - \frac{\mu_o M_s^2}{2} z\,(N_{zz} - N_{xx})\right] = A\left(K_{eff}(V = 0)\, z + \Delta K_s(V)\right)$$

où $K_s$ est le coefficient d'anisotropie d'interface. Le coefficient $\beta$ de VCMA est défini comme le rapport entre la variation $\Delta K_S(V)$ de l'anisotropie d'interface par le champ électrique à travers la barrière tunnel, soit V/w où $w$ est l'épaisseur de la barrière tunnel 120. Ainsi le coefficient $\beta$ de VCMA s'exprime comme :

[Math. 21]

$$\beta = \frac{\Delta K_s(V)w}{V}$$

d'unité fJ/V/m. Expérimentalement, le coefficient $\beta$ est typiquement compris entre 30 fJ/V/m et 150 fJ/V/m pour des interfaces entre des alliages FeCoB et MgO.

L'application d'une tension électrique de 1V à travers la barrière tunnel d'une mémoire selon l'art antérieur, présentant une hauteur de barrière énergétique élevée (ex : rétention de 10 ans à température ambiante) implique une variation d'anisotropie d'interface $\Delta K_S$ de l'ordre de 10 % par rapport à la situation où la tension appliquée est nulle. Ainsi, la VCMA est trop faible pour permettre à elle seule la commutation de l'aimantation libre dans une mémoire de l'art antérieure.

En revanche, le dispositif selon l'invention est caractérisé par une hauteur $\Delta E$ de barrière réduite. Ainsi, la variation d'anisotropie d'interface $\Delta K_S$ devient substantielle par rapport à cette hauteur de barrière réduite, permettant de réduire la hauteur de barrière d'au moins 50 %, voire induire la disparition de l'axe facile 230 ou du cône facile 240 et la création d'un plan facile correspondant au plan de référence. Ce dernier cas contribue très favorablement au retournement de l'aimantation de la couche libre.

La mesure de l'orientation de l'aimantation de la couche libre est réalisée de préférence par la mesure d'un signal de magnétorésistance tunnel. La mesure dudit signal de magnétorésistance tunnel met en œuvre la circulation d'un courant électrique au sein du dispositif. Afin de réduire le risque de retournement de l'aimantation, la polarité de la tension électrique V appliquée à travers la barrière tunnel est avantageusement opposée à la polarité de la tension électrique V appliquée à travers la barrière tunnel pour réaliser la commutation de l'aimantation libre. Ainsi l'anisotropie d'interface est augmentée, réduisant la probabilité de retournement de l'aimantation. L'ouverture du cône facile est également réduite par l'application de cette tension de lecture, permettant d'augmenter l'amplitude du signal de magnétorésistance tunnel.

Afin de faciliter le retournement de l'aimantation libre, la couche libre présente avantageusement un coefficient de VCMA élevé à l'interface avec une couche d'oxyde (et/ou de nitrure). Les valeurs de coefficient de VCMA recherchés sont préférentiellement supérieures à 30 fJ/V/m et de manière encore préférée supérieures à 100 fJ/V/m. Pour y parvenir, la couche libre peut être réalisée à partir d'un alliage de Co et de Fe. Les alliages de Heusler tels que le $Co_2MnSi$, le $Co_2Mn_{1.29}Al$, le $Co_2FeAl_{0.5}Si_{0.5}$, le $Co_2FeAl$, le $Co_2Cr_{0.6}Fe_{0.4}Al$ ou encore le $Co_2Fe_{0.4}Mn_{0.6}Si$ permettent également d'obtenir des coefficients de VCMA élevés.

La couche libre est avantageusement soumise à un champ magnétique planaire, sensiblement aligné selon le plan de référence. Par "sensiblement aligné", on entend aligné à $\pm20°$. Diverses façons d'appliquer un champ magnétique sur une couche libre ont déjà été proposées dans le contexte de mémoires magnétiques de type MRAM mettant en œuvre le couplage spin-orbite (dite SOT-MRAM pour "spin orbit transfer magnetic random access memory" en anglais) et pour lesquelles la même exigence de champ magnétique planaire existe. Le champ magnétique planaire peut être issu d'une source externe telle qu'un aimant permanent ou une couche magnétique figée, disposé à proximité du dispositif et rayonnant un champ magnétique statique dans le plan de référence. Il s'agit des solutions les moins coûteuses en termes de consommation d'énergie.

Selon une alternative, l'anisotropie $\varepsilon$ de la couche libre comprend un second terme d'anisotropie d'ordre un, orienté dans le plan de référence et venant s'ajouter au premier terme d'anisotropie d'ordre un, orienté hors du plan de référence.

Une première façon d'y parvenir comprend la réalisation de la couche libre de sorte qu'elle présente une forme elliptique dans le plan de référence. La forme elliptique induit un champ démagnétisant selon le grand axe de ladite ellipse qui s'ajoute à l'anisotropie $\varepsilon$ de la couche libre. On choisira toutefois un rapport d'aspect de l'ellipse compris entre 1,2 et 3 de sorte que l'anisotropie $\varepsilon$ effective reste hors du plan de référence. L'ajout d'un champ démagnétisant dans le plan de référence brise la symétrie de rotation de l'aimantation autour de la normale au plan de référence. Le champ d'anisotropie de forme associé joue le rôle du champ planaire nécessaire à la commutation magnétique de la couche libre par VCMA.

Une deuxième façon d'y parvenir comprend le traitement de la couche libre de manière à créer un agencement cristallographique particulier du matériau appartenant à ladite couche résultant en un second terme d'anisotropie uniaxiale orienté dans le plan de référence. On procède par exemple au recuit de la couche libre sous un fort champ magnétique, par exemple de l'ordre de 1 T, appartenant au plan de référence. Au sein d'alliages de type FeCo ou NiFe ou plus généralement à base de Fer Fe, de Cobalt Co ou de Nickel NI, un agencement à l'échelle atomique se produit lors du recuit sous champ magnétique induisant le second terme d'anisotropie uniaxiale le long de la direction d'application du fort magnétique. Ce phénomène est appelé « anisotropie de paires ». Il correspond à un agencement particulier à l'échelle atomique des atomes de deux espèces différentes (par exemple Ni et Fe) lors du recuit sous champ fort.

Une troisième façon d'y parvenir comprend la mise en œuvre de la magnétostriction de certains matériaux magnétiques résultant de l'application d'une déformation mécanique. Par exemple, certains alliages de $Co_xFe_yB_{1-x-z}$ sont caractérisés par une forte magnétostriction permettant de générer le second terme d'anisotropie uniaxiale dans le plan.

Enfin, une quatrième façon d'y parvenir est illustré par la figure 3. Le second terme d'anisotropie uniaxiale est issue d'un couplage d'échange avec une sixième couche 170 antiferromagnétique, par exemple en IrMn, en contact avec la couche libre 110, créant une anisotropie d'échange ("exchange bias" ou "exchange anisotropy" en anglais) dans le plan de référence 101. La personne du domaine sait qu'une telle anisotropie d'échange apparaît après avoir recuit l'ensemble au-dessus de la température de blocage de la sixième couche 170 antiferromagnétique et après l'avoir laissée refroidir jusqu'à la température ambiante sous un champ magnétique orienté dans le plan de référence 101, ledit champ magnétique étant suffisamment important pour saturer l'aimantation de la couche libre 110 lors du refroidissement dans le plan de référence 101.

La couche libre présente un facteur d'amortissement, dit également facteur de Gilbert, qu'il est préférable de choisir entre 0,02 et 0,4. Le facteur d'amortissement rend compte de la dissipation de l'énergie de l'aimantation de la couche libre lorsque cette dernière est mise en mouvement.

Pour ajuster le facteur de Gilbert, des impuretés présentant un fort couplage spin-orbite sont ajoutées à l'alliage formant la couche libre. Il peut s'agit de terre-rares tels que : le Dysprosium Dy, le Terbium Tb ou de métaux lourds tels que : Platine Pt, l'Or Au, le Tungstène W, le Tantale Ta ou l'Iridium Ir ou encore une combinaison de ces sept éléments. Ces éléments peuvent être incorporés au sein de la couche libre ou bien déposés sur cette dernière, formant une fine couche de lamination ou "dusting layer" en anglais. Afin de ne pas réduire l'amplitude de la magnétorésistance tunnel ou l'anisotropie d'interface, la couche de lamination est préférentiellement déposée sur une première face de la couche libre 110, opposée à une deuxième face de la couche libre 110 en contact avec la barrière tunnel 120. La couche de lamination peut être disposée entre la couche libre 110 et la sixième couche 170 antiferromagnétique. Toutefois, l'épaisseur de la couche de lamination est configurée pour conserver le couplage d'échange entre la sixième couche 170 antiferromagnétique et la couche libre 110.

Selon un mode de réalisation, la couche libre et la couche de référence comprennent un alliage de $LaSrMnO_3$ et la barrière tunnel comprend un alliage de $SrTiO_3$. La jonction tunnel magnétique ainsi formée est de type $LaSrMnO_3/SrTiO_3/LaSrMnO_3$, semi-métallique et présente une magnétorésistance tunnel importante à très basse température, de l'ordre de 1800 % à 4 K.

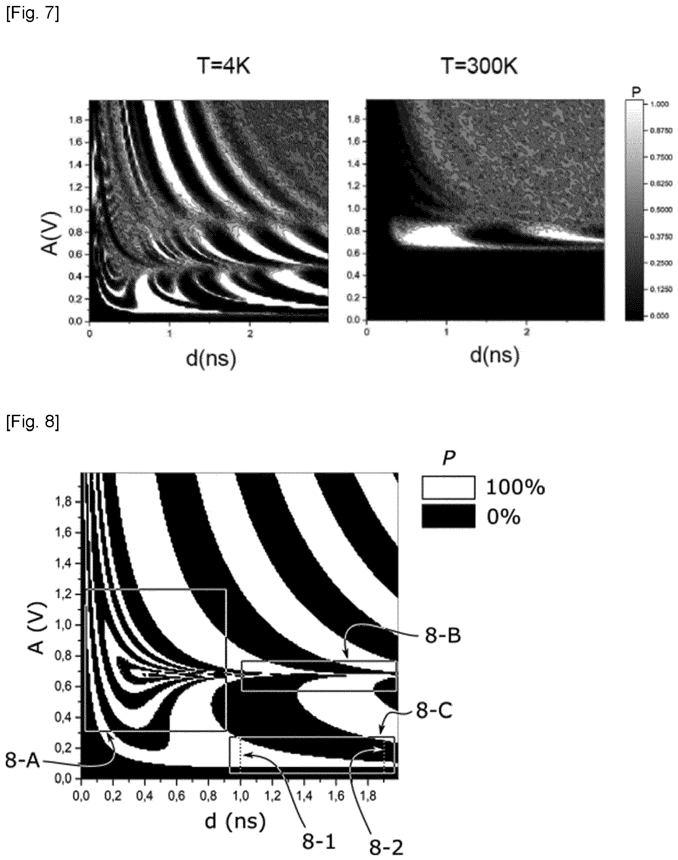

Les figures 7 et 8 présentent des résultats de simulation numérique du dispositif selon l'invention en fonction des paramètres de l'impulsion de tension et de la température.

Le modèle numérique 600 correspondant au dispositif selon l'invention est illustré par la figure 6. Les discussions, résultats et conclusions qui sont obtenus pour le modèle numérique 600 sont transposables au dispositif magnétique selon l'invention.

Le modèle numérique 600 décrit le mouvement de l'aimantation libre 601 par un macrospin obéissant à la loi de Landau-Lifshitz-Gilbert-Slonczewski. Les fluctuations thermiques sont modélisées par un champ magnétique aléatoire. Le modèle comprend notamment :

- une couche libre 610, s'étendant suivant un plan de référence et comprenant une aimantation libre 601 ;

- un champ magnétique planaire 603, appliqué sur la couche libre 610 dans le plan de référence;

- une anisotropie magnétique comprenant des termes d'anisotropie d'ordre un et d'ordre deux, induisant une anisotropie de cône facile dont l'axe est perpendiculaire au plan de référence ;

- une barrière énergétique, séparant une première orientation et une deuxième orientation, présentant une hauteur de 3000 $k_B$;

- un facteur de Gilbert égal à 0,1 ;

- une couche de référence 640 présentant une aimantation de référence 602, figée perpendiculairement au plan de référence ; et

- une barrière tunnel 620 séparant la couche libre 610 et une couche de référence 640.

La table ci-dessous rappelle les caractéristiques mise en œuvre dans le modèle.

[Table 2]

| Dimensions | 30 nm × 30 nm × 2 nm |
|---|---|
| $N_{xx}$, $N_{yy}$ | 0,0733 |
| $N_{zz}$ | 0,853 |
| $K_1$ | $0,420 \times 10^6$ J/m³ |
| $K_1^{eff}$ | $0,023 \times 10^6$ J/m³ |
| $K_2$ | $-0,023 \times 10^6$ J/m³ |
| $M_8$ | $0,9 \times 10^6$ A/m |
| $\beta$ | -300 fJ/V/m |
| $\alpha$ | 0,1 |
| $H_0$ | 10 mT |
| TMR | 100 % |
| $R_p$ | 300 $k\Omega$ |

La figure 7 présente deux cartographies de la probabilité de commutation P en fonction de l'amplitude A et de la durée d de l'impulsion de tension appliquée sur la barrière tunnel. La polarité de l'impulsion de tension électrique appliquée est configurée pour réduire l'anisotropie d'interface.

La stabilité thermique à 4 K et à température ambiante est identique est fixée à $\Delta$ = 50, la hauteur de la barrière énergétique étant ajustée pour chaque température. Chaque pixel des figures de la figure 7 est simulé 50 fois afin d'obtenir une probabilité P de commutation l'aimantation libre.

Dans le premier graphique, correspondant à 4 K, l'alternance de zones correspondant à une probabilité de commutation P >> 0 et de P << 1 indique que la commutation de l'aimantation libre s'effectue par retournement précessionnel cohérent, avec une forte cohérence due à la faiblesse des fluctuations thermiques. Cette alternance de zones (P >> 0 et P << 1) n'est pas observée sur le deuxième graphique car les fluctuations thermiques à 300 K sont trop importantes.

La différence la plus frappante entre les deux résultats correspond à l'amplitude minimale A de la tension électrique pour laquelle une probabilité de commutation P non-nulle est observée. À 4 K, la hauteur de barrière étant réduite, une amplitude A moindre est nécessaire pour permettre la commutation. Des simulations complémentaires permettent d'ailleurs de montrer que la commutation à $T$ = 4$K$ est toujours observée même pour un champ magnétique planaire H inférieur à 10 mT ou une amplitude A d'impulsion électrique de quelques dizaines de millivolt seulement.

Le retournement précessionnel de l'aimantation selon l'art antérieur est difficile à mettre en œuvre car il requiert un contrôle très précis des paramètres de l'impulsion de courant mise en œuvre. Il est possible de le mettre en œuvre pour un point mémoire individuel ; en revanche, il est plus difficile, voire impossible, de contrôler le retournement précessionnel de milliers de points mémoires à l'échelle d'une puce mémoire, notamment à cause de la déformation des impulsions se propageant le long des conducteurs électriques à l'intérieur de la puce. Un meilleur intervalle de tolérance des paramètres de l'impulsion de tension est obtenu grâce au dispositif selon l'invention.

La figure 8 présente une cartographie de la probabilité de commutation P de l'aimantation libre en fonction de l'amplitude A et la durée d de l'impulsion de tension. À la différence des cartographies de la figure 7, la simulation est réalisée à température nulle, c'est à dire sans fluctuations thermiques. Toutefois une hauteur de barrière de 3000 $k_B$ est considérée.

Trois caractéristiques peuvent être observée : des boucles de commutation dans une première région 8-A, des bandes de coupure dans une deuxième région 8-B et des bandes de commutation dans une troisième région 8-C.

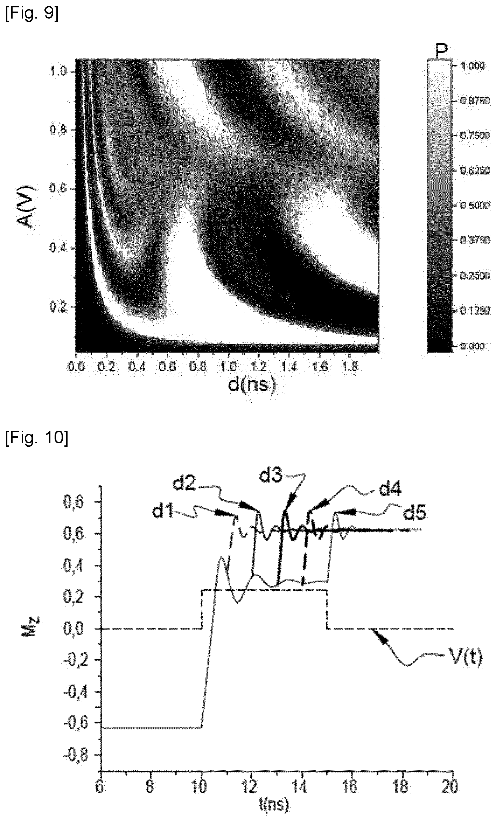

Les boucles de commutation et les bandes de coupures sont très sensibles aux fluctuations thermiques. La figure 9 montre par exemple, une cartographie de la probabilité de commutation pour une température de 4 K, où l'on peut noter l'absence de boucles de commutation et de bandes de coupures. Il est donc difficile de tirer avantage de ces points de fonctionnement pour réaliser la commutation de l'aimantation libre dans un cadre appliqué.

En revanche, les bandes de commutation (troisième région 8-C) montre une bonne robustesse aux fluctuations thermiques à 4 K (observables dans la figure 9). Les bandes de commutation présentent donc un intérêt pour réaliser l'écriture d'une information sur le dispositif magnétique par VCMA.

En l'absence d'un champ magnétique externe appliqué perpendiculairement au plan de référence, les résultats des simulations sont identiques qu'il s'agisse de retournement de la première orientation vers la deuxième orientation ou de la deuxième orientation vers la première orientation.

Toutefois, dans le cadre d'un dispositif réel, un tel champ externe perpendiculaire pourrait exister à cause du champ rayonné par la couche de référence. Il est toutefois connu de l'homme du métier que ce champ rayonné peut toutefois être limité par la mise en œuvre d'une couche référence de type antiferromagnétique synthétique. Si toutefois un champ magnétique externe est appliqué, il modifie les cartographies de retournement mais pas les types de structures que l'on peut observer, telles que les bandes de commutations.

Les bandes de commutation sont intéressantes du point de vue applicatif car en choisissant un point de fonctionnement au sein desdites bandes de commutation, on peut contrôler le retournement de l'aimantation de la couche libre avec une probabilité de retournement de 100 % obtenue avec une très grande tolérance sur la durée des pulses autour du point de fonctionnement.

Dès lors qu'une amplitude minimale $A_c$ et une durée minimale $d_c$, dites amplitude et durée critiques, sont atteintes, la probabilité de retournement est constante, quelques soit la durée $d > d_c$ de l'impulsion de tension. À l'inverse des résultats montrés dans l'art antérieur, la durée $d$ de l'impulsion de tension offre un large intervalle de tolérance pour mener à bien le retournement de la première aimantation.

Par exemple, la figure 10 montre la variation temporelle d'aimantation selon la normale au plan de référence $M_z$ pour différentes durées d'impulsion $d_1, d_2, d_3, d_4, d_5$ s'étendant de 1 ns et 5 ns. Sur cette figure, l'impulsion de tension commence à l'instant $t = 10$ ns et se termine à l'instant $t = 10$ns $+ d_i$, avec $d_i$ représentant les durées d'impulsion $d_1, d_2, d_3, d_4, d_5$. Sur la figure 10, seulement la variation $V(t)$ pour le pulse de 5 ns est représentée. Ainsi, quel que soit la durée $d$ de l'impulsion de tension, l'aimantation libre commute vers l'état opposé et converge vers la nouvelle orientation stable, sans rebond pour revenir à l'orientation initiale.

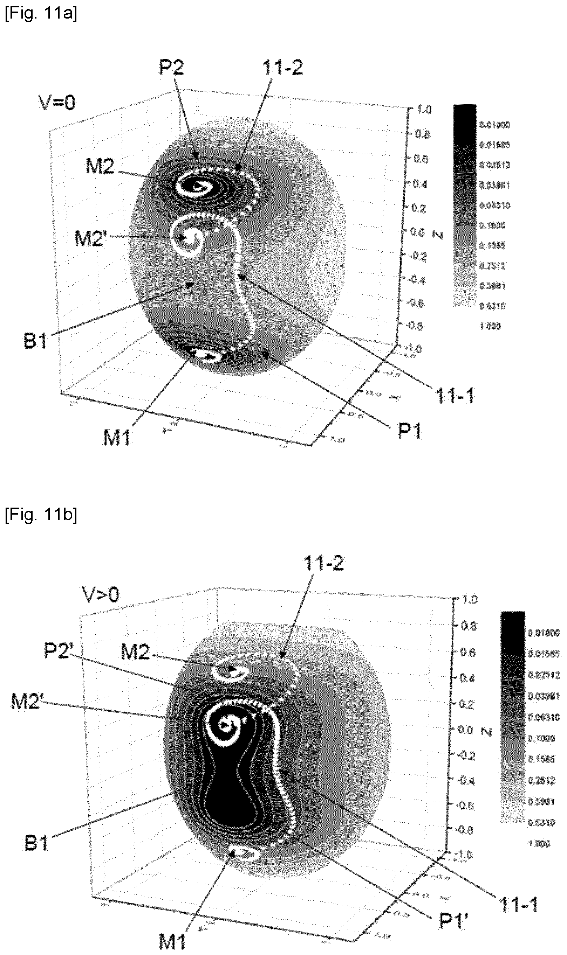

Les figures 11a et 11b représentent schématiquement une première trajectoire 11-1 et une deuxième trajectoire 11-2 suivies séquentiellement par l'aimantation libre lors de la commutation, mettant en œuvre l'effet de la VCMA. Les trajectoires matérialisent le déplacement de la pointe de l'aimantation libre sur une sphère unité. Le code couleur à la surface de ces sphères représente l'énergie magnétique totale de la couche libre, c'est à dire, le paysage énergétique dans lequel évolue l'aimantation libre.

Le paysage d'énergie de la figure 11a montre un premier puit P1 et un deuxième puit P2 séparés par une barrière d'énergie. Le premier puit P1 correspond à la première orientation stable et le deuxième puit P2 correspond à la deuxième orientation. L'énergie représentée correspond à la somme d'une anisotropie de cône facile ayant un axe de cône perpendiculaire au plan de référence plus l'énergie Zeeman associée au couplage de l'aimantation de la couche libre à un champ magnétique planaire. Ainsi, du fait de l'application du champ planaire, les orientations stables sont légèrement déviées de la normale au plan de référence et les deux puits P1, P2 sont rapprochés sur un côté de la sphère. La barrière d'énergie présente ainsi un point de selle B1 qui correspond à la barrière énergétique minimale qu'il faut franchir pour passer d'un puit à l'autre, par exemple de P1 à P2.

La figure 11b montre la déformation du paysage d'énergie lorsqu'une tension électrique est appliquée aux bornes de la barrière tunnel. La polarité de l'impulsion est configurée pour réduire la hauteur de la barrière d'énergie, abaissant le point de selle B1. Les deux puits P1', P2' se sont également rapprochés du point de selle B1.

Le retournement de l'aimantation libre par VCMA s'effectue en trois temps. Dans un premier temps le système est au repos et l'énergie totale de la couche libre est illustrée par la figure 11a. L'aimantation est au fond du premier puit P1, dans une première orientation M1.

Lorsque l'impulsion de tension est appliquée au dispositif magnétique, et pendant toute la durée de l'impulsion magnétique, l'anisotropie magnétique est modifiée ce qui modifie l'énergie totale, illustré par la figure 11b. L'aimantation libre, se trouvant au point M1 n'est plus au niveau de plus basse énergie et amorce un mouvement de précession. En l'absence d'amortissement, la précession s'effectue à énergie constante et suit les courbes d'iso-énergie du paysage énergétique. L'amortissement, caractérisé par le facteur de Gilbert, dissipe une quantité de puissance ayant pour effet de déformer la trajectoire associée à la précession de l'aimantation de sorte qu'elle converge vers un minimum local d'énergie. Dans l'exemple de la figure 11b, l'aimantation a suivi la première trajectoire 11-1 et a convergé dans le deuxième puit P2', dans une deuxième orientation M2'. À ce stade, le système est stable et l'aimantation occupera le deuxième puits P2' aussi longtemps que la tension électrique est maintenue aux bornes de la barrière tunnel.

Enfin, l'application de la tension électrique est interrompue et le paysage énergétique reprend sa forme initiale, illustrée par la figure 11a. L'aimantation, occupant l'orientation M2' n'est plus au niveau de plus basse énergie et amorce un nouveau mouvement de précession, suivant la deuxième trajectoire 11-2, qui la fait converger au fond du deuxième puit P2, selon l'orientation M2. L'orientation M2' présente une énergie inférieure au point de selle B1, le retour en arrière lorsque la tension électrique est coupée n'est donc pas possible.

Lorsque la tension est appliquée, l'aimantation converge vers l'orientation M2 grâce, d'une part, au mouvement de précession déclenché par l'abaissement de l'anisotropie au moment où le pulse de tension est appliqué et d'autre part, à l'amortissement. Le facteur de Gilbert considéré dans cette simulation est égal à 0,1 et est suffisamment élevé pour que l'aimantation puisse rejoindre le fond du deuxième puit P2' avant l'arrêt de l'application de la tension électrique aux bornes de la barrière tunnel sans être non plus trop élevé pour que l'énergie communiquée à l'aimantation de la couche douce par l'abaissement de l'anisotropie magnétique ne soit pas entièrement dissipée avant que l'aimantation n'est réussie à passer la barrière d'énergie séparant les deux puits P1, P2'.

Dans la discussion ci-dessus, il a été montré que le retournement de l'aimantation peut être obtenu avec un grand intervalle de tolérance sur la durée de l'impulsion, dès lors que l'amplitude critique $A_c$ est atteinte. Toutefois, il peut également être difficile de contrôler précisément l'amplitude de l'impulsion de tension, notamment le long des lignes conductrices d'une puce électronique. Les impulsions électriques tendent à s'élargir à mesure qu'elles se propagent, réduisant corrélativement leurs amplitudes de manière difficilement contrôlable.

L'invention permet de mettre en œuvre une impulsion de tension selon un point de fonctionnement permettant d'obtenir un intervalle de tolérance suffisant à la fois pour l'amplitude et la durée de l'impulsion.

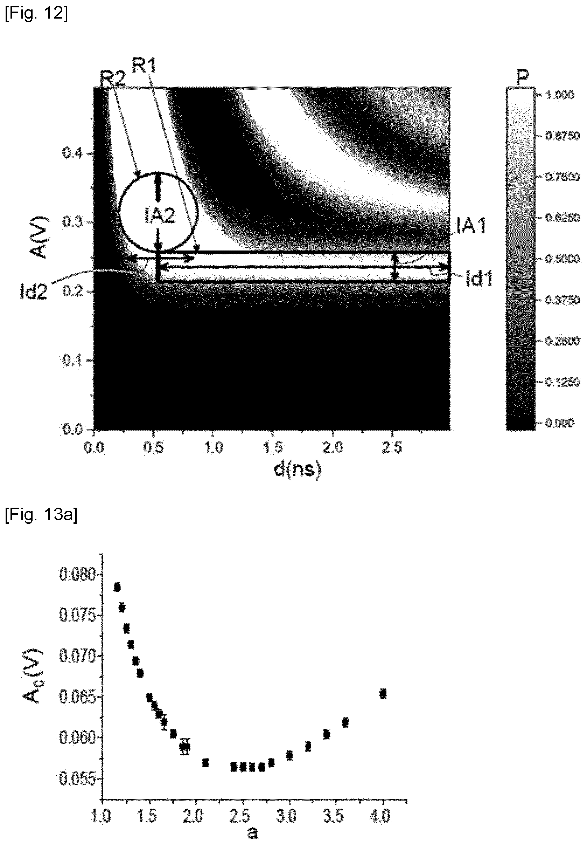

La figure 12 représente un résultat de simulation de la probabilité de retournement de la première aimantation en fonction de l'amplitude A et de la durée d de l'impulsion de tension. La figure 12 représente notamment une première région R1, de forme rectangulaire et une deuxième région R2, de forme circulaire. Ces régions correspondent à un ensemble de points de fonctionnement (A, d) de l'impulsion de tension, qu'il peut être envisageable de mettre en œuvre.

La première région R1 correspond à une bande de commutation, comme présenté dans la figure 8, pour laquelle un premier intervalle de tolérance ID1 de la durée est très grand. On observe toutefois qu'un deuxième intervalle de tolérance IA1 de l'amplitude n'excède pas 50 mV. Au-delà du deuxième intervalle de tolérance, la probabilité de commutation décroît fortement.

La deuxième région R2 occupe un disque au sein de la même bande de commutation que la première région R1. Au sein de la deuxième région, un troisième intervalle de tolérance id2 de la durée de l'impulsion est inférieure au premier intervalle de tolérance id1. En revanche, un quatrième intervalle de tolérance IA2 sur l'amplitude de l'impulsion est plus grand que le deuxième intervalle de tolérance IA1.Ainsi, le dispositif magnétique peut disposer à la fois d'une première et une deuxième région R1, R2. Le choix du point de fonctionnement à considérer dépend évidemment du domaine d'application du dispositif et des conditions opératoires. L'avantage de la région R1 est d'offrir une grande tolérance sur la durée de l'impulsion mais une faible tolérance sur l'amplitude de l'impulsion alors que la région R2 offre un bon compromis en tolérance à la fois sur la durée et l'amplitude de l'impulsion de tension.

Le deuxième intervalle de tolérance IA1 sur l'amplitude A de l'impulsion peut être augmenté en diminuant l'intensité du champ magnétique planaire appliqué sur l'aimantation libre. En effet, un champ de 2 mT permet d'obtenir un deuxième intervalle de tolérance IA1 de l'ordre de 50 mV alors qu'un champ de 10 mT le réduit drastiquement. Toutefois, la réduction du champ magnétique planaire réduit également la fiabilité de la commutation de la couche libre du dispositif lors d'un événement d'écriture en présence de fluctuations thermiques.

En revanche, le quatrième intervalle de tolérance IA2 sur l'amplitude A de l'impulsion montre une bonne robustesse quel que soit le champ magnétique planaire appliqué. Ainsi, un dispositif magnétique selon l'invention, destiné à être mis en œuvre avec une impulsion de tension dont le point de fonctionnement se situe dans la deuxième région R2, est plus robuste aux fluctuations thermiques et aux variations de fabrication.

Par exemple, le résultat de simulation illustré par la figure 12 est réalisé pour une température de 4 K. Les fluctuations thermiques ont un impact plus faible au voisinage de la deuxième région R2 qu'au voisinage de la première région R1. Ainsi, le quatrième intervalle de tolérance IA2 se réduit d'environ 15 % entre 0 K et 4 K alors que le deuxième intervalle de tolérance IA1 se réduit d'environ 70 %.

Au lieu de l'application d'un champ magnétique planaire, le retournement par VCMA peut tirer avantageusement partie d'un terme d'anisotropie d'ordre un (uniaxiale) appartenant au plan de référence et ajouté à l'anisotropie magnétique effective du dispositif. Afin d'obtenir un terme d'anisotropie uniaxiale dans le plan de référence, la couche libre peut présenter une forme d'ellipse dans le plan de référence. Toutefois, le remplacement de l'application d'un champ magnétique par une anisotropie uniaxiale dans le plan de référence modifie la dynamique de précession de l'aimantation, notamment à cause de l'aspect bidirectionnel du terme d'anisotropie uniaxiale.

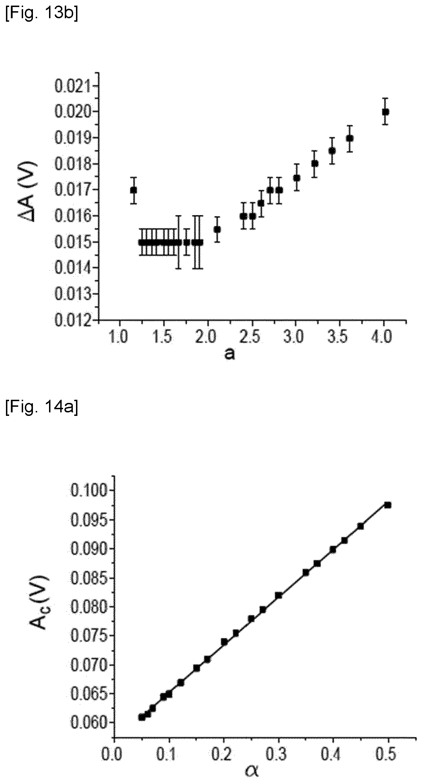

Les figures 13a et 13b montrent des résultats de simulations numériques en fonction d'un rapport d'aspect $\alpha$ de la couche libre. Le rapport d'aspect correspond au rapport de la longueur du grand axe par la longueur du petit axe de l'ellipse.

La figure 13a montre l'évolution de l'amplitude critique $A_c$ en fonction du rapport d'aspect a. L'amplitude critique $A_c$ correspond à l'amplitude nécessaire pour réaliser le retournement de l'aimantation libre. L'amplitude critique $A_c$ pour réaliser le retournement est minimale autour d'un rapport d'aspect $\alpha$ de l'ordre de 2,5.

La figure 13b montre l'évolution de l'intervalle de tolérance $\Delta A$ sur l'amplitude de l'impulsion en fonction du rapport d'aspect a. L'intervalle de tolérance $\Delta A$ croît à partir d'un rapport d'aspect $\alpha$ de 2.

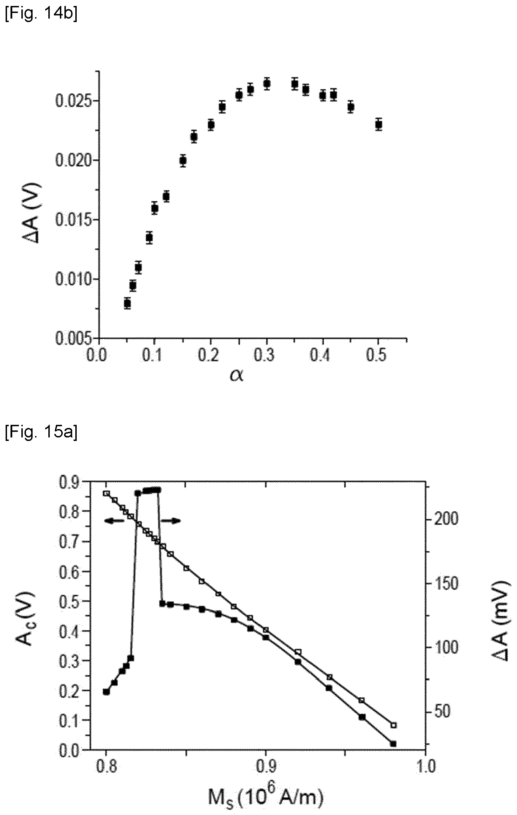

Les figures 14a et 14b illustrent la dépense de l'amplitude critique $A_c$ et l'intervalle de tolérance $\Delta A$ autour de cette amplitude critique en fonction du facteur de Gilbert $\alpha$. Le dispositif simulé comprend notamment une forme d'ellipse dans le plan de référence et un rapport d'aspect de 1,5. La durée de l'impulsion de tension considérée est 3 ns.

L'amplitude critique $A_c$ croît linéairement avec le facteur de Gilbert $\alpha$, toutefois la pente est faible. Par exemple, l'amplitude critique $A_c$ augmente de 35 % lorsque le facteur de Gilbert $\alpha$ croît d'un facteur 5.

La variation de l'intervalle de tolérance $\Delta A$ en fonction du facteur de Gilbert $\alpha$ est plus prononcée et montre un maximum autour de $\alpha = 0,3$. Ceci indique que le facteur de Gilbert $\alpha$ doit être préférentiellement choisi dans un intervalle compris entre 0,02 et 0,4.

Afin d'améliorer la robustesse du retournement tout en réduisant l'amplitude $A$ de l'impulsion de tension, il est préférable de considérer un grand intervalle de tolérance $\Delta A$ Pour cela le facteur de Gilbert $\alpha$ doit être préférentiellement choisi dans un intervalle compris entre 0,05 et 0,3 et de manière encore préférée entre 0,1 et 0,3.

L'amplitude critique $A_c$ peut être estimée de manière théorique en fonction des différents paramètres du dispositif, tels que les paramètres matériaux. En considérant que le retournement intervient lorsque l'énergie de l'aimantation libre est égale à l'énergie du sommet de la barrière séparant les deux orientations stables, alors la densité d'énergie $\epsilon$ est donnée par :

[Math. 19]

$$\epsilon(\theta, \varphi) = -K_{eff}(V) \cos \theta^{\,2} - K_2 \cos \theta^{\,4} - \mu_o M_S H \sin \theta \cos \varphi$$

où $\theta$ est l'angle de l'aimantation avec la normale au plan de référence et $\varphi$ est l'angle de la projection de l'aimantation dans le plan de référence avec le grand axe de la couche libre. En présence d'un champ magnétique planaire H, aligné avec le grand axe de la couche libre (ou simplement dans le plan de référence si cette dernière est circulaire), l'aimantation est déviée vers le plan de référence d'un angle $\theta_0$. L'état d'équilibre minimise la densité d'énergie $\epsilon$ selon :

[Math. 20]

$$\begin{cases} \left.\dfrac{\partial}{\partial \theta} \epsilon(\theta_0, \varphi = 0°)\right|_{A=0} = 0 \\ (\sin \theta_0)^3 - \left(1 + \dfrac{K_{eff}}{2\,K_2}\right) \sin \theta_0 + \dfrac{\mu_o M_S H}{4K_2} = 0 \end{cases}$$

Ainsi, l'amplitude critique $A_c$ pour obtenir le retournement est donnée par :

[Math. 21] $\qquad -(\mathrm{K}_{eff} + \beta A_c) \cos \theta_0{}^2 - K_2 \cos \theta_0{}^4 - \mu_o M_S H \sin \theta_0 = -\mu_o M_S H$

c'est à dire :

[Math. 22]

$$A_c = \frac{1}{\beta}\left[\frac{\mu_o M_S H(1 - \sin \theta_0)}{\cos \theta_0{}^2} - K_2 \cos \theta_0{}^2 - K_{eff}\right]$$

Les figures 15a à 15e illustrent l'influence de plusieurs paramètres sur la commutation de l'aimantation par VCMA, notamment l'influence sur l'amplitude critique $A_c$ à partir de laquelle le retournement devient possible ainsi que l'intervalle de tolérance $\Delta A$ autour de l'amplitude critique $A_c$.

Les résultats des figures 15a à 15e sont obtenus par simulation du dispositif magnétique en considérant les propriétés de la table 3 et un facteur de Gilbert $\alpha = 0,2$. Ils sont également obtenus au moyen d'expressions analytiques telles que détaillées précédemment en considérant un facteur de Gilbert $\alpha = 0,0$. Les tendances illustrées par les figures 15a à 15e fournissent ainsi un support afin de dimensionner les propriétés du dispositif magnétique.

[Table 3]

| Dimensions | 30 nm $\times$ 30 nm $\times$ 2 nm |
|---|---|
| $N_{xx}$, $N_{yy}$ | 0,0733 |
| $N_{zz}$ | 0,0853 |
| $K_1$ | 0,500 $\times$ 10$^6$ J/m$^3$ |
| $K_1^{eff}$ | 0,038 $\times$ 10$^6$ J/m$^3$ |
| $K_2$ | -0,057 $\times$ 10$^6$ J/m$^3$ |
| $M_s$ | 0,95 $\times$ 10$^6$ A/m |
| $\beta$ | -300 fJ/V/m |
| $H$ | 20 mT |

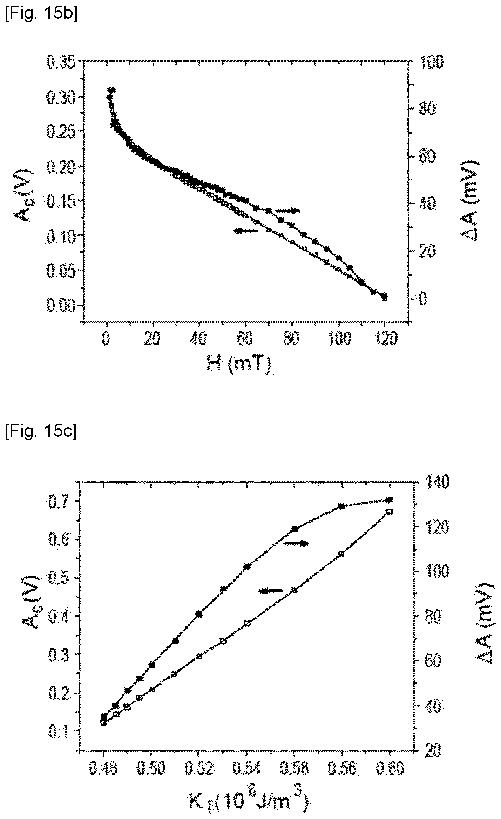

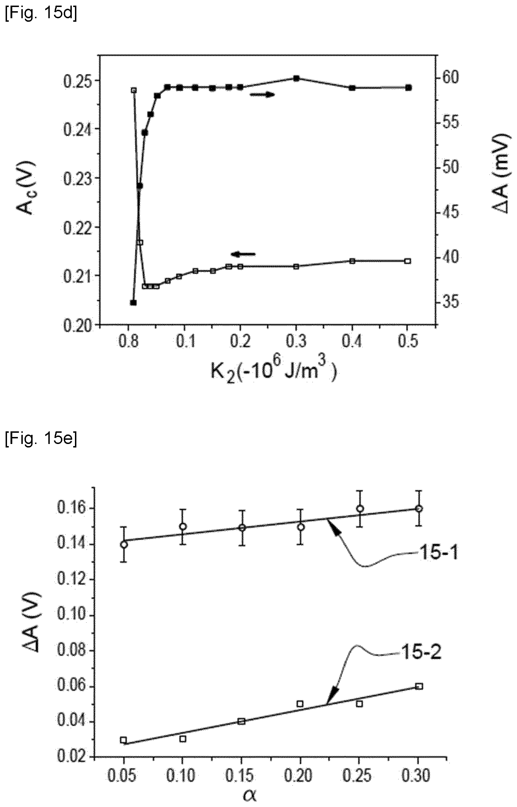

Les figures précitées illustrent la variation d'amplitude critique $A_c$ et d'intervalle de tolérance $\Delta A$ en fonction de l'aimantation à saturation $M_s$ pour la figure 15a, du champ magnétique planaire H pour la figure 15b, du coefficient d'anisotropie d'ordre un $K_1$ pour la figure 15c et du coefficient d'anisotropie d'ordre deux $K_2$ pour la figure 15d.

Le saut d'intervalle de tolérance $\Delta A$ observable dans la figure 15a correspond à la fusion de deux bandes de commutation. Toutefois ce régime particulier semble difficile à mettre en œuvre pratiquement car très sensible aux fluctuations thermiques, même à basse température (4 K dans cet exemple).

L'amplitude critique $A_c$ décroît pour des valeurs du coefficient d'anisotropie d'ordre deux $K_2$ négatives, inférieures en valeur absolue à 0,3 10$^5$ J/m$^3$, et tend vers une valeur asymptotique à mesure que $K_2$ augmente en valeur absolue. L'intervalle de tolérance $\Delta A$ atteint un plateau lorsque le coefficient d'anisotropie d'ordre 2 $K_2$ dépasse en valeur absolue 10$^5$ J/m$^3$, confirmant l'amélioration du retournement par VCMA lorsque les orientations stables s'appuient sur une anisotropie de cône facile.

La figure 15e montre la variation de l'intervalle de tolérance $\Delta A$ en fonction du facteur de Gilbert pour une durée d'impulsion de 1,0 ns (courbe 15-1) et 1,9 ns (courbe 15-2). Ces deux courbes correspondent aux deux coupes 8-1, 8-2 matérialisées dans la figure 8. L'intervalle de tolérance $\Delta A$ varie linéairement avec le facteur de Gilbert, montrant une amélioration de la reproductibilité du retournement par VCMA lorsqu'on augmente l'amortissement de Gilbert à l'intérieur de l'intervalle considéré.

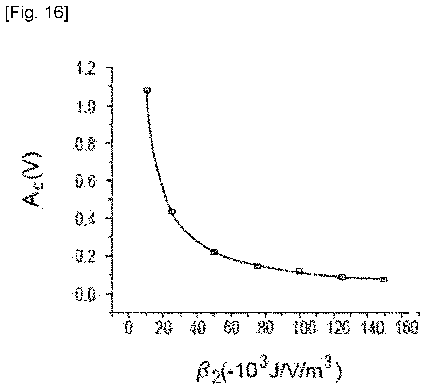

La figure 16 montre l'évolution de l'amplitude critique $A_c$ en fonction du coefficient $\beta$ de VCMA. Il est intéressant de noter que l'effet du coefficient $\beta$ sur l'amplitude critique $A_c$ diminue à mesure que le coefficient $\beta$ augmente en valeur absolue. Ainsi, des valeurs modérées de coefficients $\beta$, telles que celles obtenues à l'interface entre une couche libre en CoFeB et une barrière tunnel en MgO, sont suffisantes pour réaliser un dispositif dont le retournement est effectué par VCMA.

La lecture de l'état du dispositif 100 est réalisée par la mesure de la résistance du dispositif. Pour cela un courant électrique circule à travers le dispositif et la variation de résistance, fonction de la magnétorésistance tunnel, permet de déterminer l'orientation relative de l'aimantation libre par rapport à l'aimantation fixe.

Afin de faciliter la lecture de l'état inscrit au sein du dispositif, la jonction tunnel magnétique présente préférentiellement une magnétorésistance élevée. Le rapport de magnétorésistance tunnel d'une jonction tunnel magnétique comprenant une barrière tunnel en MgO est dans l'état de l'art compris entre 200 % et 600% à température ambiante suivant la composition des électrodes magnétiques et la température de recuit utilisée après le dépôt des couches. Cette magnétorésistance tunnel augmente à basse température et peut doubler lorsqu'on passe de 300K à 4K. Une magnétorésistance élevée permet de différencier rapidement l'état de forte et basse résistance, offrant une vitesse de lecture accrue.

La barrière tunnel peut comprendre une monocouche d'oxyde ou une monocouche de nitrure ou encore un empilement des monocouches précitées. Toutefois, la barrière tunnel est caractérisée par un produit de sa résistance par sa surface dit produit "RA". Son unité est Q·μm$^2$. La composition et l'épaisseur de la barrière tunnel sont configurées de manière à fournir un produit RA supérieur ou égal à 10 Q·μm$^2$ et préférentiellement supérieur ou égal à 100 $\Omega$·μm$^2$. De la sorte, la densité de courant électrique circulant au sein du dispositif lors de la phase d'écriture est limitée et permet ainsi de réduire la consommation électrique dudit dispositif. Afin de réduire davantage la consommation électrique, le produit RA peut être supérieur ou égal à 1000 $\Omega$·μm$^2$. En revanche, de telles valeurs de produit RA peuvent réduire de manière excessive la vitesse de lecture de l'état du dispositif car conduisent à une baisse importante du courant de lecture traversant la jonction.

Lors de la lecture de l'état du dispositif 100, la tension aux bornes de la barrière tunnel ne doit pas être trop importante, l'amplitude de la magnétorésistance tunnel diminuant avec la tension. Toutefois un courant de lecture faible implique un temps de lecture plus grand. Ainsi, on choisira avantageusement une tension de lecture comprise entre 0,15 V et 0,4 V. À titre d'exemple, le dispositif présentant un diamètre de 50 nm, une barrière tunnel caractérisée par un produit RA de 100 $\Omega \cdot \mu$m$^2$ (la résistance de la barrière tunnel étant prépondérante par rapport aux autres contributions), présente une résistance totale de l'ordre de 51 k$\Omega$. Le courant électrique circulant dans le dispositif auquel une tension électrique de 0,4 V est appliquée est d'environ 7 $\mu$A. Le temps de lecture minimum est approximativement d'une nanoseconde. Si la barrière tunnel présente une résistance de surface de 1000 $\Omega \cdot \mu$m$^2$ alors le courant électrique circulant dans le dispositif auquel une tension électrique de 0,4 V est appliquée est d'environ 0,7 $\mu$A. Le temps de lecture minimum est approximativement d'une dizaine de nanoseconde. La durée d'application du courant électrique de lecture est significativement plus longue que la durée de l'impulsion de tension pour l'écriture.

De façon avantageuse, la polarité de la tension de lecture, autrement dit le signe de la tension de lecture, est choisie opposée à la polarité de la tension d'écriture, c'est à dire au signe de la tension d'écriture, De la sorte, la composante perpendiculaire au plan de référence de l'anisotropie magnétique de la couche libre est renforcée par la tension de lecture alors qu'elle était diminuée par la tension d'écriture.

**Revendications**

1. Dispositif (100) magnétique cryogénique contrôlé en tension comportant :

   - une première couche (110) magnétique, dite couche libre, s'étendant suivant un plan (101) de référence et présentant une première aimantation (301), dite aimantation libre, et une anisotropie ($\varepsilon$) magnétique favorisant l'orientation de l'aimantation libre selon une première orientation (210) ou une deuxième orientation (220), la première orientation comprenant une première composante perpendiculaire au plan de référence et la deuxième orientation comprenant une deuxième composante perpendiculaire au plan de référence, la première composante perpendiculaire et la deuxième composante perpendiculaire étant de signes opposés, l'anisotropie magnétique étant définie par une barrière énergétique séparant la première orientation et la deuxième orientation, l'amplitude ($\Delta E$) de la barrière énergétique étant inférieure à 6300 $k_B$, la couche libre présentant un facteur d'amortissement de Gilbert compris entre 0,02 et 0,4;
   - une deuxième couche (120) isolante non-magnétique, dite barrière tunnel, s'étendant au contact de la couche libre ; et
   - un moyen (131, 132) configuré pour appliquer une impulsion de tension ($V$) à travers la barrière tunnel, ladite impulsion de tension étant adaptée pour réduire l'amplitude de la barrière énergétique et commuter l'aimantation libre de :

      ∘ la première orientation à la deuxième orientation ; ou de
      ∘ la deuxième orientation à la première orientation.

2. Dispositif selon la revendication précédente, dans lequel ledit moyen (131, 132) est configuré pour contrôler l'anisotropie magnétique ($\varepsilon$) de la couche libre (110) par une tension appliquée par effet de contrôle de l'anisotropie magnétique par la tension dit effet VCMA.

3. Dispositif selon l'une des revendications précédentes, comprenant une troisième couche (140) magnétique et conductrice, dite couche de référence, s'étendant au contact de la barrière tunnel et présentant une deuxième aimantation (302), dite aimantation de référence, fixe et sensiblement perpendiculaire au plan de référence, la couche de référence étant apte à transmettre les impulsions de tension à la barrière tunnel.

4. Dispositif selon l'une des revendications précédentes, dans lequel le facteur d'amortissement de Gilbert de la couche libre est compris entre 0,05 et 0,3.

5. Dispositif selon l'une des revendications précédentes, dans lequel la couche libre présente une première épaisseur (z) choisie pour que l'amplitude de la barrière énergétique soit inférieure à 6300 $k_B$.

6. Dispositif selon l'une des revendications précédentes, dans lequel la couche libre présente une anisotropie magnétique telle que la première orientation et la deuxième orientation appartiennent à :

   - un axe (230) facile, sensiblement perpendiculaire au plan de référence ; ou

- un cône (240) facile, l'axe du cône facile étant sensiblement perpendiculaire au plan de référence.

**7.** Dispositif selon l'une des revendications précédentes, comportant un moyen pour appliquer un champ magnétique planaire (H) au niveau de la couche libre, au moins pendant la durée d'application de l'impulsion de tension, ledit champ magnétique planaire étant sensiblement contenu à l'intérieur du plan de référence.

**8.** Dispositif selon l'une des revendications précédentes, comprenant une couche (170) antiferromagnétique adaptée pour appliquer une anisotropie d'échange au niveau de la couche libre.

**9.** Dispositif selon l'une des revendications précédentes, dans lequel la couche libre présente une anisotropie magnétique comprenant une composante uniaxiale sensiblement contenue à l'intérieur du plan de référence.

**10.** Dispositif selon la revendication précédente, dans lequel la couche libre présente une structure cristallographique configurée pour induire la composante d'anisotropie uniaxiale sensiblement contenue dans le plan de référence.

**11.** Dispositif selon l'une des deux revendications précédentes, dans lequel la couche libre présente une forme d'ellipse dans le plan de référence, le rapport (*a*) d'aspect de l'ellipse étant compris entre 1,2 et 3.

**12.** Dispositif selon l'une des revendications précédentes, dans lequel la barrière tunnel est choisie telle que le produit de sa résistance par sa surface soit supérieur à $10 \, \Omega \cdot \mu m^2$.

**13.** Dispositif selon l'une des revendications précédentes, dans lequel la couche libre comprend un alliage à base de Fer et un élément amorphisant avantageusement choisi parmi les éléments suivants : Bore, Zirconium, Niobium, Hafnium ou une combinaison de ces éléments amorphisants.

**14.** Dispositif selon l'une des revendications précédentes, dans lequel la couche libre comprend des impuretés présentant un fort couplage spin-orbite.

**15.** Dispositif selon l'une des revendications précédentes, dans lequel la couche libre comprend une première face, en contact avec la barrière tunnel et une deuxième face, opposée à la première face, en contact avec une couche de lamination apte à produire une augmentation du facteur d'amortissement de Gilbert, cette couche de lamination comprenant des impuretés présentant un fort couplage spin-orbite.

**16.** Dispositif selon l'une des revendications précédentes, dans lequel l'impulsion de tension comprend :

- une première polarité configurée pour réduire l'amplitude de la barrière énergétique, de durée et d'amplitude choisies pour commuter l'aimantation libre ; et
- une deuxième polarité opposée à la première polarité et configurée pour augmenter l'amplitude de la barrière énergétique, de durée et d'amplitude choisies pour permettre la lecture de l'état magnétique de la couche libre.

[Fig. 1a]

[Fig. 1b]

[Fig. 1c]

[Fig. 2a]

[Fig. 2b]

[Fig. 3]

[Fig. 4a]

[Fig. 4b]

[Fig. 4c]

[Fig. 5]

$\Delta K_s(V)$

$\theta$

[Fig. 6]

[Fig. 7]

T=4K    T=300K

[Fig. 8]

[Fig. 9]

[Fig. 10]

[Fig. 11a]

[Fig. 11b]

[Fig. 12]

[Fig. 13a]

[Fig. 13b]

[Fig. 14a]

[Fig. 14b]

[Fig. 15a]

[Fig. 15b]

[Fig. 15c]

[Fig. 15d]

[Fig. 15e]

[Fig. 16]

Europäisches
Patentamt

European
Patent Office

Office européen
des brevets

# RAPPORT DE RECHERCHE EUROPEENNE

Numéro de la demande

EP 22 15 6192

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | LANG LILI ET AL: "A low temperature functioning CoFeB/MgO-based perpendicular magnetic tunnel junction for cryogenic nonvolatile random access memory", APPLIED PHYSICS LETTERS, AMERICAN INSTITUTE OF PHYSICS, 2 HUNTINGTON QUADRANGLE, MELVILLE, NY 11747, vol. 116, no. 2, 14 janvier 2020 (2020-01-14), XP012243754, ISSN: 0003-6951, DOI: 10.1063/1.5129553 [extrait le 2020-01-14] * page 1, colonne de gauche, alinéa 1 – page 4, colonne de gauche, dernier alinéa; figures 1-4 * | 1-16 | INV. G11C11/16 |
| X | ZHANG KAILI ET AL: "Compact Modeling and Analysis of Voltage-Gated Spin-Orbit Torque Magnetic Tunnel Junction", IEEE ACCESS, IEEE, USA, vol. 8, 11 mars 2020 (2020-03-11), pages 50792-50800, XP011778950, DOI: 10.1109/ACCESS.2020.2980073 * page 50792, colonne de droite, alinéa 2 – page 50793, colonne de droite, alinéa 2; figure 1 * * page 50795, colonne de gauche, alinéa 4 * * page 50796, colonne de gauche, alinéa 2 – page 50798, colonne de droite, alinéa 2; figures 3-6; tableaux 1,2 * | 1-16 | DOMAINES TECHNIQUES RECHERCHES (IPC) G11C H01L H01F |

-----

-----

-/--

Le présent rapport a été établi pour toutes les revendications

| Lieu de la recherche | Date d'achèvement de la recherche | Examinateur |
|---|---|---|
| La Haye | 7 juin 2022 | Colling, Pierre |

EPO FORM 1503 03.82 (P04C02)

Europäisches
Patentamt

European
Patent Office

Office européen
des brevets

## RAPPORT DE RECHERCHE EUROPEENNE

Numéro de la demande

EP 22 15 6192

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A,D | NOZAKI TAKAYUKI ET AL: "Recent Progress in the Voltage-Controlled Magnetic Anisotropy Effect and the Challenges Faced in Developing Voltage-Torque MRAM", MICROMACHINES, vol. 10, no. 5, 15 mai 2019 (2019-05-15), page 327, XP055873953, ISSN: 2072-666X, DOI: 10.3390/mi10050327 * page 21, dernier alinéa * ----- | 1-16 | |

DOMAINES TECHNIQUES
RECHERCHES (IPC)

Le présent rapport a été établi pour toutes les revendications

| Lieu de la recherche | Date d'achèvement de la recherche | Examinateur |
|---|---|---|
| La Haye | 7 juin 2022 | Colling, Pierre |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.........................................................................
& : membre de la même famille, document correspondant

EPO FORM 1503 03.82 (P04C02)

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **TAKAYUKI KAWAHARA.** *J. Appl. Phys.,* 2011, vol. 109, 07D325
- **VERNIK, I. V. et al.** Magnetic Josephson junctions with superconducting interlayer for cryogenic memory. *IEEE Trans. Appl. Supercond.,* 2013, vol. 23, 1701208
- **G. E. ROWLANDS et al.** A cryogenic spin-torque memory element with precessional magnetization dynamics. *Scientific Reports,* 2019, vol. 9, 803
- **L. REHM et al.** Sub-nanosecond switching in a cryogenic spin-torque spin-valve memory element with a dilute permalloy free layer. *Appl. Phys. Lett.,* 2019, vol. 114, 212402
- **L. REHM et al.** Sub-nanosecond spin-torque switching of perpendicular magnetic tunnel junction nanopillars at cryogenic temperatures. *Appl. Phys. Lett.,* 2019, vol. 115, 182404
- **T. NOZAKI et al.** Recent progress in the voltage-controlled magnetic anisotropy effect and the challenges faced in developing voltage-torque MRAM. *Micromachines,* 2019, vol. 10 (5), 327
- **C. GREZES et al.** Write error rate and read disturbance in electric-field-controlled magnetic-random-access memory. *IEEE Magn. Lett.,* 2017, vol. 8
- **T. YAMAMOTO et al.** Improvement of write error rate in voltage-driven magnetization switching. *J. Phys. D Appl. Phys.,* 2019, vol. 52, 164001
- **TEIXEIRA, B. M. S. et al.** Ion irradiation-induced easy-cone anisotropy in double-MgO free layers for perpendicular magnetic tunnel junctions. *Appl. Phys. Lett.,* 2018, vol. 112, 202403